# EUROPEAN PATENT APPLICATION

(11) **EP 4 839 031 A1**
(43) Date of publication of application: **11.11.2026**
(21) Application number: 25741999.4
(22) Date of filing: 16.01.2025
(51) Int. Cl.: H05K 3/40, H05K 1/11

(54) **METHOD FOR MANUFACTURING SUBSTRATE WITH CONDUCTIVE THROUGH-VIA, METAL PASTE, AND SUBSTRATE WITH CONDUCTIVE THROUGH-VIA**

(30) Priority: 17.01.2024 JP 2024005289
(71) Applicant: Resonac Corporation, Tokyo 105-7325 (JP)
(72) Inventor: EJIRI Yoshinori, Tokyo 105-7325 (JP); SAKAMOTO Masumi, Tokyo 105-7325 (JP); SHIMIZU Chiaki, Tokyo 105-7325 (JP)
(74) Representative: Hoffmann Eitle
(86) International application number: PCT/JP2025/001207
(87) International publication number: WO 2025/154774

(57) **Abstract**

A method for manufacturing a substrate with conductive vias comprises: step a of preparing a substrate provided with a hole and providing a metal paste part containing metal particles and a volatile solvent to cover at least a surface of the substrate surrounding the hole while filling the inside of the hole; step b of heating the metal paste part to remove a part of the volatile solvent; step c of removing a part of the metal paste part after heating to expose the surface, thereby forming a conductive via precursor in the inside of the hole, the conductive via precursor comprising the metal particles and a remainder of the volatile solvent and having a planarized exposed surface; and step d of firing the conductive via precursor, wherein the metal particles comprise first metal particles having a volume average particle diameter of 0.8 µm or more and second metal particles having a volume average particle diameter of 0.5 µm or less, the metal paste part provided in step a has a metal particle concentration of 95.0% by mass or more, and a content of the second metal particles in the metal paste part provided in step a is 50% by mass or less based on a total amount of the metal particles.

The above-described method for manufacturing a substrate with conductive vias is also useful as a technology for reducing an environmental burden caused by plating.

## Description

### Technical Field

The present invention relates to a method for manufacturing a substrate with conductive vias, a metal paste, and a substrate with conductive vias.

### Background Art

In recent years, in order to reduce the size, increase the functionality, and achieve the integration of electronic devices or components, a three-dimensional mounting technology has attracted attention, in which silicon substrates arranged in a top-and-bottom arrangement are electrically connected to each other via an electrode called a through silicon via (TSV), and semiconductor chips are stacked in a vertical direction (height direction) at a high density.

As a technique for forming a through electrode, for example, Patent Literature 1 discloses a method for manufacturing a semiconductor device having a through silicon via, the method including a step of performing copper plating on a blind-via formed on a silicon substrate by electroplating using a specific copper plating solution. However, such a method has problems in terms of productivity due to the environmental burden of plating and a long operation time resulting from the need to perform plating while reducing the deposition rate of a copper film.

As another technique, a method is known in which a copper conductor paste containing copper powder, glass powder, an organic vehicle, and the like is filled into through-holes of a heat-resistant substrate and fired to form a copper conductor in the through-holes (for example, Patent Literature 2 below and other publications).

### Citation List

### Patent Literature

[Patent Literature 1] Japanese Unexamined Patent Publication No. 2019-16712
[Patent Literature 2] Japanese Unexamined Patent Publication No. 2010-108917

### Summary of Invention

### Technical Problem

Recently, the inner diameter of through-holes has become extremely small along with the reduction in size of silicon substrates to accommodate the miniaturization of electronic devices or components, and it has become necessary to form conductive vias having sufficient conductivity even in such through-holes. In addition, wiring may be further provided by plating or other processes on a surface of the substrate in which the conductive vias are formed, and even in this case, the substrate is required to exhibit a sufficiently low connection resistance value.

In addition, recently, higher signal speeds, miniaturization of substrates, and lower power consumption through shorter transmission distances are being pursued, and further improvement in connection reliability beyond what has been achieved conventionally is required. Under such circumstances, a substrate with conductive vias on which the above-described wiring is formed (wiring board) is required to be not only excellent in conductivity but also excellent in the characteristic that the connection resistance value is unlikely to increase even when the substrate is subjected to temperature changes (hereinafter, also referred to as "connection reliability").

Therefore, an object of the present invention is to provide a method for manufacturing a substrate with conductive vias that can exhibit a sufficiently low connection resistance value even after wiring formation and enables a resulting wiring board to have excellent connection reliability, and a metal paste capable of being used in the method.

### Solution to Problem

As a result of intensive studies to achieve the above-described object, the present inventors have found that a factor in increasing the connection resistance value after wiring formation is a low planarity (or smoothness) of conductive vias on a surface of a substrate with conductive vias (i.e., a large step height between a conductive via part and the substrate surface). As a result of studying a method for reducing the said step height based on this finding, the present inventors have found that by forming a conductive via through specific steps using a metal paste containing specific metal particles and a volatile solvent, a sufficiently low connection resistance value can be obtained even when a wiring connected to the conductive via is further formed, and moreover, the resulting wiring board has excellent connection reliability, and have thus completed the present invention.

That is, one aspect of the present invention relates to the following method for manufacturing a substrate with conductive vias.
[1] A method for manufacturing a substrate with conductive vias, the method comprising: step a of preparing a substrate provided with a hole and providing a metal paste part containing metal particles and a volatile solvent to cover at least a surface of the substrate surrounding the hole while filling an inside of the hole; step b of heating the metal paste part to remove a part of the volatile solvent; step c of removing a portion of the metal paste part after heating to expose the surface, thereby forming a conductive via precursor in the inside of the hole, the conductive via precursor comprising the metal particles and a remainder of the volatile solvent and having a planarized exposed surface; and step d of firing the conductive via precursor, wherein the metal particles comprise first metal particles having a volume average particle diameter of 0.8 µm or more and second metal particles having a volume average particle diameter of 0.5 µm or less, the metal paste part provided in step a has a metal particle concentration of 95.0% by mass or more, and a content of the second metal particles in the metal paste part provided in step a is 50% by mass or less based on a total amount of the metal particles.

According to the above-described manufacturing method, after providing, in step a, the metal paste part containing the volatile solvent and having the above-described specific metal particle configuration, it is possible, through step b and step c, to achieve both good filling of the inside of the hole and formation of the conductive via precursor that is less likely to undergo volume shrinkage by firing, and it is possible to form, through step d, a conductive via having excellent conductivity in which the occurrence of cracks and voids is sufficiently suppressed while sufficiently reducing the step height with respect to the substrate surface. Thereby, it is possible to obtain a substrate with conductive vias exhibiting a sufficiently low connection resistance value even after wiring formation. Further, the substrate with conductive vias having the wire formation (wiring board) can possess excellent connection reliability.
[2] The method for manufacturing a substrate with conductive vias according to [1], wherein the first metal particles and the second metal particles are copper particles.
[3] The method for manufacturing a substrate with conductive vias according to [1] or [2], wherein the first metal particles comprise flake-shaped copper particles.

In addition, another aspect of the present invention relates to the following metal paste.
[4] A metal paste comprising metal particles and a volatile solvent, wherein a content of the metal particles is 95.0% by mass or more based on a total amount of the metal paste, the metal particles comprise first metal particles having a volume average particle diameter of 0.8 µm or more and second metal particles having a volume average particle diameter of 0.5 µm or less, and a content of the second metal particles is 50% by mass or less based on a total amount of the metal particles.
[5] The metal paste according to [4], wherein the first metal particles and the second metal particles are copper particles.
[6] The metal paste according to [4] or [5], wherein the first metal particles comprise flake-shaped copper particles.

According to the above-described metal paste, sufficient printability can be obtained, and the metal paste part can be efficiently formed in the above-described method for manufacturing a substrate with conductive vias.

In addition, another aspect of the present invention relates to the following substrate with conductive vias.
A substrate with conductive vias, comprising a substrate having a through-hole and a conductive via provided in the through-hole, wherein the conductive via comprises a sintered body of the metal paste according to any one of [4] to [6].

### Advantageous Effects of Invention

According to the present invention, it is possible to provide a method for manufacturing a substrate with conductive vias that is capable of exhibiting a sufficiently low connection resistance value even after wiring formation and enabling a resulting wiring board to have excellent connection reliability, and a metal paste capable of being used in the method, as well as a substrate with conductive vias.

### Brief Description of Drawings

FIG. 1 is a schematic diagram illustrating an example of a method for manufacturing a substrate with conductive vias according to the present embodiment.
FIG. 2 is a schematic diagram illustrating an example of the method for manufacturing a substrate with conductive vias according to the present embodiment.
FIG. 3 is a schematic diagram illustrating an example of the method for manufacturing a substrate with conductive vias according to the present embodiment.
FIG. 4 is a schematic diagram illustrating an example of a method for forming a wiring.
FIG. 5 is a schematic diagram illustrating a test piece.
FIG. 6 is a cross-section photograph of a conductive via in a conductive via-containing silicon substrate produced in Example 1.
FIG. 7 is a cross-section photograph of a conductive via in a silicon substrate with conductive vias produced in Comparative Example 1.

### Description of Embodiments

Hereinafter, embodiments of the present invention will be described in detail with reference to the drawings. The present invention is not limited to the following embodiments. In the drawings, the same or corresponding parts are denoted by the same reference numerals, and their repetitive description will be omitted.

### <Metal Paste>

The metal paste of the present embodiment contains metal particles and a volatile solvent, and the content of the metal particles is 95.0% by mass or more based on the total amount of the metal paste. The metal paste of the present embodiment can be used for forming a metal paste part in a method for manufacturing a substrate with conductive vias as will be described later.

The content of the metal particles in the metal paste of the present embodiment may be 95.2% by mass or more, 95.5% by mass or more, 95.7% by mass or more, or 96% by mass or more, or may be 98% by mass or less, 97% by mass or less, or 96.5% by mass or less, or may be 95.0% to 98% by mass, 95.2% to 97% by mass, or 95.7% to 96.5% by mass, based on the total amount of the metal paste.

### [Metal Particles]

Examples of the metal particles include particles of nickel, silver, copper, gold, palladium, platinum, solder, and the like. The metal particles may contain a plurality of metals, such as silver-coated copper particles. When the metal paste contains copper particles, it is easy to obtain a conductor having sufficient conductivity and a resistance value that is unlikely to increase even when subjected to a temperature change, and a base having a through electrode with sufficient conductivity and excellent connection reliability. In the present embodiment, the metal particles include first metal particles having a volume average particle diameter of 0.8 µm or more and second metal particles having a volume average particle diameter of 0.5 µm or less.

In the present specification, the volume average particle diameter of particles (hereinafter, also referred to as "average particle diameter" in some cases) means a 50% volume average particle diameter (D50). When the volume average particle diameter of the metal particles is determined, the volume average particle diameter can be determined by a method of dispersing metal particles serving as a raw material in a dispersion medium such as water or alcohol and measuring the resulting dispersion with a laser diffraction/scattering particle size distribution analyzer, or other methods.

The first metal particles and the second metal particles may be copper particles from the viewpoint of reducing resistance, ensuring resistance to ion migration, and ease of wiring formation. The present embodiment will be described in detail by taking as an example a case where the first metal particles are copper particles (hereinafter referred to as "first copper particles") and the second metal particles are copper particles (hereinafter referred to as "second copper particles").

### (First Copper Particles)

The average particle diameter of the first copper particles may be 0.8 µm or more, 1.0 µm or more, 2.0 µm or more, or 3.0 µm or more from the viewpoint of improving the sintering density in the hole(s) (for example, a through-hole(s) or a blind-hole(s)) of the substrate and suppressing the occurrence of voids and cracks in the hole, may be 10 µm or less, 8.0 µm or less, 5.0 µm or less, or 4.0 µm or less, for example, from the viewpoint of suppressing clogging of particles in a fine via having an inner diameter of 100 µm or less and improving the fillability, or may be 0.8 µm to 4.0 µm, 1.0 µm to 3.5 µm, or 1.2 µm to 3.0 µm from the viewpoint of suppressing voids and cracks and suppressing clogging of particles in the fine via. The ratio (DC1/DH) of the average particle diameter DC1 of the first copper particles to the inner diameter DH of the hole may be 0.01 or more, 0.03 or more, or 0.04 or more from the viewpoint of suppressing clogging of particles in the fine via and improving the fillability, or may be 0.15 or less, 0.1 or less, or 0.05 or less from the viewpoint of suppressing voids and cracks by reducing shrinkage caused by firing. In addition, from the above-described viewpoints, the ratio (DC1/DH) may be 0.01 to 0.15 or 0.03 to 0.1.

The shape of the first copper particles may be, for example, a spherical shape, an agglomerated shape, a needle shape, a flat shape (flake shape), an approximately spherical shape, or the like shapes. The first metal particles may be an aggregate of copper particles having these shapes. The metal paste of the present embodiment can contain spherical copper particles as the first copper particles from the viewpoint of reducing a step height between the conductive via part to be formed and the substrate surface and suppressing the fluctuation in connection resistance even after a reliability test (for example, a temperature cycle test).

In the first copper particles, the content ratio of particles having an aspect ratio of 2 or less, such as spherical particles, may be 40% by mass or more, 50% by mass or more, 60% by mass or more, 80% by mass or more, or 100% by mass, or may be 40% to 90% by mass, 50% to 80% by mass, or 60% to 70% by mass, from the viewpoint of improving the printability of the metal paste. The aspect ratio (major axis/minor axis) of a particle can be determined, for example, by observing an SEM image of the particle and measuring the major axis and the minor axis (for example, thickness).

In addition, the metal paste of the present embodiment may contain flake-shaped copper particles as the first copper particles from the viewpoint of suppressing voids and cracks by reducing shrinkage caused by firing, and may contain spherical copper particles and flake-shaped copper particles from the viewpoint of suppressing voids and cracks by reducing the viscosity of the metal paste to improve the fillability into fine vias and reducing shrinkage caused by firing. When spherical copper particles and flake-shaped copper particles are used in combination, a mass ratio thereof (spherical copper particles)/(flake-shaped copper particles) may be 1 to 9, 1.2 to 2.5, or 1.4 to 4.

The flake-shaped copper particles may have an aspect ratio of 1.5 or more, 2 or more, or 3 or more.

When spherical copper particles having an aspect ratio of 2 or less and flake-shaped copper particles having an aspect ratio of more than 2 are used in combination, a mass ratio thereof (spherical copper particles)/(flake-shaped copper particles) may be 0.6 to 9, 1.0 to 4.0, or 1.5 to 2.4.

The first copper particles may be produced by a chemical reduction method, an atomization method, an electrolytic method, a pulverization method, a plasma rotating electrode process, a homogeneous droplet spraying method, a heat treatment method, or the like, or may be a wet copper powder or an atomized copper powder from the viewpoint of easily obtaining a uniform diameter and improving the dispersibility of the metal paste.

The first copper particles may contain a wet copper powder. In this case, a conductive via having excellent conductivity is easily obtained. It is considered that such an effect is obtained based on the properties of the wet copper powder being easily bonded to the copper particles blended as the second metal. The wet copper powder may have a D90/D50 of 1.5 or less.

In addition, the copper particles can contain a wet copper powder and an atomized copper powder. In this case, it is easy to improve the printability of the metal paste, reduce the step height between the conductive via part to be formed and the substrate surface, and suppress fluctuation in connection resistance even after a reliability test (for example, a temperature cycle test). The reason such an effect can be obtained is inferred as follows. Specifically, it is considered that since the wet copper powder that is easily bonded to the second copper particles and that has a uniform particle diameter and the atomized copper powder that has a wide particle size distribution coexist, the wet copper powder bonds to the second copper particles while bonding the particles of the atomized copper powder together, and as a result, it is possible to achieve the formation of a strong sintered body based on the close-packed structure, and the suppression of shrinkage during sintering to suppress the occurrence of voids and cracks and suppress recesses. The atomized copper powder may have a D90/D50 of 1.6 or more, 1.7 or more, or 1.8 or more.

When the first copper particles contain the wet copper powder and the atomized copper powder, the content ratio of the wet copper powder may be more than 0 parts by mass and less than 100 parts by mass, or may be 20 to 80 parts by mass, with respect to a total of 100 parts by mass of the wet copper powder and the atomized copper powder.

As the first copper particles, commercially available products can be used. Examples of the commercially available first copper particles include 1050Y (manufactured by MITSUI MINING & SMELTING CO., LTD., trade name, average particle diameter (D50): 0.81 µm, D90: 1.1 µm, spherical shape, wet copper powder), 1100Y (manufactured by MITSUI MINING & SMELTING CO., LTD., trade name, average particle diameter (D50): 1.1 µm, D90: 1.6 µm, spherical shape, wet copper powder), 1200Y (manufactured by MITSUI MINING & SMELTING CO., LTD., trade name, average particle diameter (D50): 2.1 µm, D90: 3.1 µm, spherical shape, wet copper powder), 1300Y (manufactured by MITSUI MINING & SMELTING CO., LTD., trade name, average particle diameter (D50): 3.5 µm, D90: 5 µm, spherical shape, wet copper powder), 1100YP (manufactured by MITSUI MINING & SMELTING CO., LTD., trade name, average particle diameter (D50): 1.4 µm, D90: 2.3 µm, flat shape, wet copper powder), 1200YP (manufactured by MITSUI MINING & SMELTING CO., LTD., trade name, average particle diameter (D50): 3.1 µm, D90: 5.3 µm, flat shape, wet copper powder), MA-C02K (manufactured by MITSUI MINING & SMELTING CO., LTD., trade name, average particle diameter (D50): 1.8 µm, D90: 3.6 µm, spherical shape, atomized copper powder), MA-C025K (manufactured by MITSUI MINING & SMELTING CO., LTD., trade name, average particle diameter (D50): 2.4 µm, D90: 5.2 µm, spherical shape, atomized copper powder), and MA-C03K (manufactured by MITSUI MINING & SMELTING CO., LTD., trade name, average particle diameter (D50): 3.4 µm, D90: 6.3 µm, spherical shape, atomized copper powder).

The first copper particles may have been treated with a surface treatment agent from the viewpoint of dispersion stability and oxidation resistance. The surface treatment agent may be removed during wiring formation (during sintering of copper particles). Examples of such a surface treatment agent include: aliphatic carboxylic acids such as palmitic acid, stearic acid, arachidic acid, and oleic acid; aromatic carboxylic acids such as terephthalic acid, pyromellitic acid, and o-phenoxybenzoic acid; aliphatic alcohols such as cetyl alcohol, stearyl alcohol, isobornyl cyclohexanol, and tetraethylene glycol; aromatic alcohols such as p-phenylphenol; alkylamines such as octylamine, dodecylamine, and stearylamine; aliphatic nitriles such as stearonitrile and decanenitrile; silane coupling agents such as alkylalkoxysilane; and polymer treatment agents such as polyethylene glycol, polyvinyl alcohol, polyvinyl pyrrolidone, and silicone oligomers. The surface treatment agent may be used alone or may be used in combination of two or more kinds thereof.

The treatment amount of the surface treatment agent may be an amount of one or more molecular layers on a particle surface. The treatment amount of such a surface treatment agent varies depending on the specific surface area of the first copper particles, the molecular weight of the surface treatment agent, and the minimum coating area of the surface treatment agent. The treatment amount of the surface treatment agent is usually 0.001% by mass or more.

The treatment amount of the surface treatment agent can be calculated from the number (n) of molecular layers attached to the surface of a first copper particle, the specific surface area of the first copper particles (Aₚ) (unit: m²/g), the molecular weight of the surface treatment agent (Mₛ) (unit: g/mol), the minimum coating area of the surface treatment agent (S_{S}) (unit: m²/unit), and Avogadro's number (N_{A}) (6.02 × 10²³). Specifically, the treatment amount of the surface treatment agent is calculated according to the equation: treatment amount of surface treatment agent (% by mass) = {(n × Aₚ × Mₛ)/(S_{S} × N_{A} + n × Aₚ × Mₛ)} × 100%.

The specific surface area of the first copper particles can be calculated by measuring the dried copper particles in accordance with the BET specific surface area measurement method. When the surface treatment agent is a linear saturated fatty acid, the minimum coating area of the surface treatment agent is 2.05 × 10⁻¹⁹ m²/one molecule. For other surface treatment agents, for example, it can be measured by calculation from a molecular model or the method described in "Chemistry and Education" (Katsuhiro Ueda, Sumio Inafuku, and Iwao Mori, 40 (2), 1992, pp. 114-117). An example of a quantitative method of the surface treatment agent will be described. The surface treatment agent can be identified with a thermal desorption gas chromatograph mass spectrometer using a dry powder obtained by removing the dispersion medium from the metal paste, thereby enabling the number of carbon atoms and the molecular weight of the surface treatment agent to be determined. The carbon content ratio in the surface treatment agent can be analyzed by carbon content analysis. Examples of the carbon content analysis method include a high-frequency induction heating furnace combustion-infrared absorption method. The amount of the surface treatment agent can be calculated from the number of carbon atoms, the molecular weight, and the carbon content ratio of the identified surface treatment agent by the above-described equation.

### (Second Copper Particles)

The average particle diameter of the second copper particles may be 0.5 µm or less, 0.4 µm or less, 0.3 µm or less, or 0.2 µm or less from the viewpoint of sinterability, may be 0.01 µm or more, 0.03 µm or more, 0.05 µm or more, 0.08 µm or more, or 0.1 µm or more from the viewpoint of reducing synthesis cost, good dispersibility, and reducing the use amount of a surface treatment agent, or may be 0.1 µm to 0.3 µm, 0.12 µm to 0.28 µm, or 0.15 µm to 0.25 µm from the viewpoint of obtaining sinterability at a low temperature and good dispersibility in the paste.

The second copper particles can function as copper particles that suitably bond between the first copper particles. In addition, the second copper particles are more excellent in sinterability than the first copper particles and can have a function of promoting sintering of the copper particles. For example, the copper particles can be sintered at a lower temperature as compared with a case where the first copper particles are used alone as the copper particles.

The second copper particles may be a wet copper powder produced by a chemical reduction method.

The shape of the second copper particles may be, for example, a spherical shape, an agglomerated shape, a needle shape, a flat shape (flake shape), an approximately spherical shape, or the like. The second copper particles may be an aggregate of copper particles having these shapes. From the viewpoint of dispersibility and fillability, the shape of the second copper particles may be a spherical shape, an approximately spherical shape, or a flat shape (flake shape), and from the viewpoint of flammability and mixability with the first copper particles and the like, the shape may be a spherical shape or an approximately spherical shape.

The aspect ratio of the second copper particles may be 5 or less, 4 or less, or 3 or less from the viewpoint of dispersibility, fillability, and mixability with the first copper particles.

As the second copper particles, either synthetic or commercially available products can be used. Examples of the commercially available second copper particles include CH0200L1 (manufactured by MITSUI MINING & SMELTING CO., LTD., trade name, average particle diameter (D50): 200 nm, spherical shape) and Tn-Cu100 (manufactured by TAIYO NIPPON SANSO CORPORATION, average particle diameter (D50): 120 nm, spherical shape).

The second copper particles may have been treated with a specific surface treatment agent. Examples of the specific surface treatment agent include an organic acid having 8 to 16 carbon atoms. Examples of the organic acid having 8 to 16 carbon atoms include: saturated fatty acids such as caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyltridecanoic acid, ethyldodecanoic acid, propylundecanoic acid, butyldecanoic acid, pentylnonanoic acid, hexyloctanoic acid, pentadecanoic acid, methyltetradecanoic acid, ethyltridecanoic acid, propyldodecanoic acid, butylundecanoic acid, pentyldecanoic acid, hexylnonanoic acid, palmitic acid, methylpentadecanoic acid, ethyltetradecanoic acid, propyltridecanoic acid, butyldodecanoic acid, pentylundecanoic acid, hexyldecanoic acid, heptylnonanoic acid, methylcyclohexanecarboxylic acid, ethylcyclohexanecarboxylic acid, propylcyclohexanecarboxylic acid, butylcyclohexanecarboxylic acid, pentylcyclohexanecarboxylic acid, hexylcyclohexanecarboxylic acid, heptylcyclohexanecarboxylic acid, octylcyclohexanecarboxylic acid, and nonylcyclohexanecarboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecenoic acid, hexadecenoic acid, palmitoleic acid, and sapienic acid; and aromatic carboxylic acids such as terephthalic acid, pyromellitic acid, o-phenoxybenzoic acid, methyl benzoic acid, ethyl benzoic acid, propyl benzoic acid, butyl benzoic acid, pentyl benzoic acid, hexyl benzoic acid, heptyl benzoic acid, octyl benzoic acid, and nonyl benzoic acid. The organic acid may be used alone or may be used in combination of two or more kinds thereof. By combining such an organic acid and the above-described second copper particles, the dispersibility of the second copper particles and the removability of the organic acid during sintering tend to be both achieved.

The treatment amount of the surface treatment agent may be an amount in which one-molecular layer to three-molecular layer is attached to the surface of a second copper particle. The treatment amount of the surface treatment agent may be 0.07% by mass or more, 0.10% by mass or more, or 0.2% by mass or more, or may be 2.1% by mass or less, 1.6% by mass or less, or 1.1% by mass or less. The surface treatment amount of the second copper particles can be calculated by the method described above for the first copper particles. The same applies to the specific surface area, the molecular weight of the surface treatment agent, and the minimum coating area of the surface treatment agent.

The content of the second metal particles in the metal paste is 50% by mass or less based on the total amount of the metal particles from the viewpoint of connection reliability, or may be 10% to 50% by mass or 20% to 40% by mass from the viewpoint of lowering the sintering temperature to improve adhesion to the underlying metal layer, reducing the porosity of a sintered body, suppressing shrinkage during sintering, and suppressing the occurrence of cracks.

The total content of the first copper particles and the second copper particles in the metal paste may be 100 parts by mass, 85 to 99.5 parts by mass, 90 to 99 parts by mass, or 95 to 98 parts by mass, when the total mass of the metal particles is 100 parts by mass.

The contents of the first copper particles and the second copper particles may be 50 to 90 parts by mass and 50 to 10 parts by mass, 55 to 85 parts by mass and 45 to 15 parts by mass, or 60 to 80 parts by mass and 40 to 20 parts by mass, respectively, with respect to 100 parts by mass of the total of the first copper particles and the second copper particles.

The metal paste of the present embodiment may contain copper particles and metal particles other than the copper particles (hereinafter, also referred to as "other metal particles"). In this case, the other metal particles may be nickel particles, silver particles, gold particles, palladium particles, platinum particles, or solder particles. These can be contained singly or in combination of two or more kinds thereof. The average particle diameter of the other metal particles may be 0.01 µm or more, 0.03 µm or more, or 0.05 µm or more, or may be 5 µm or less, 3.0 µm or less, or 2.0 µm or less. The average particle diameter of the solder particles may be 1.0 µm or more, 1.5 µm or more, 2.0 µm or more, 3.0 µm or more, or 4.0 µm or more, or may be 15 µm or less, 10 µm or less, 8.0 µm or less, or 5.0 µm or less.

The content of the other metal particles may be 5 parts by mass or less, 3 parts by mass or less, 1 part by mass or less, or 0.8 parts by mass or less, when the total mass of the copper particles is 100 parts by mass. The metal paste of the present embodiment may be free of solder particles as the other metal particles.

### [Volatile Solvent]

Examples of the volatile solvent include: monohydric and polyhydric alcohols such as pentanol, hexanol, heptanol, octanol, decanol, ethylene glycol, diethylene glycol, propylene glycol, butylene glycol (such as 1,3-butanediol), α-terpineol, and isobornyl cyclohexanol (MTPH); ethers such as ethylene glycol butyl ether, ethylene glycol phenyl ether, diethylene glycol methyl ether, diethylene glycol ethyl ether (ethyl carbitol), diethylene glycol butyl ether (such as diethylene glycol mono-n-butyl ether), diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether; esters such as dimethyl phthalate, ethylene glycol ethyl ether acetate, ethylene glycol butyl ether acetate, propylene glycol diacetate, diethylene glycol ethyl ether acetate, diethylene glycol butyl ether acetate, dipropylene glycol methyl ether acetate (DPMA), ethyl lactate, butyl lactate, γ-butyrolactone, and propylene carbonate; acid amides such as N-methyl-2-pyrrolidone, N,N-dimethylacetamide, and N,N-dimethylformamide; aliphatic hydrocarbons such as cyclohexane, octane, nonane, decane, and undecane; aromatic hydrocarbons such as benzene, toluene, and xylene; mercaptans containing an alkyl group having 1 to 18 carbon atoms; and mercaptans containing a cycloalkyl group having 5 to 7 carbon atoms. Examples of the mercaptans containing an alkyl group having 1 to 18 carbon atoms include ethyl mercaptan, n-propyl mercaptan, i-propyl mercaptan, n-butyl mercaptan, i-butyl mercaptan, t-butyl mercaptan, pentyl mercaptan, hexyl mercaptan, and dodecyl mercaptan. Examples of the mercaptans containing a cycloalkyl group having 5 to 7 carbon atoms include cyclopentyl mercaptan, cyclohexyl mercaptan, and cycloheptyl mercaptan. The volatile solvent may be used alone or may be used in combination of two or more kinds thereof.

The metal paste of the present embodiment may contain a solvent having a vapor pressure of 4 Pa or more and 30 Pa or less at 20°C (hereinafter, also referred to as a "high vapor pressure solvent") as a volatile solvent from the viewpoint of printability and suppressing volume shrinkage before and after firing the conductive via precursor (for example, between step C of forming the conductive via precursor and step d of firing the conductive via precursor) to suppress voids and cracks. The high vapor pressure solvent may be used alone or may be used in combination of two or more kinds thereof.

Examples of the high vapor pressure solvent include α-terpineol, 1,3-butanediol, ethyl carbitol, propylene glycol diacetate, and the like.

The metal paste of the present embodiment may contain a solvent having a vapor pressure of less than 4 Pa at 20°C (hereinafter, also referred to as a "low vapor pressure solvent") as a volatile solvent from the viewpoint of suppressing powderization by drying associated with solvent evaporation during printing or preparation of the paste. The low vapor pressure solvent may be used alone or may be used in combination of two or more kinds thereof.

Examples of the low vapor pressure solvent include isobornyl cyclohexanol (MTPH), dimethyl phthalate, diethylene glycol mono-n-butyl ether, and the like.

The metal paste of the present embodiment may contain the high vapor pressure solvent and the low vapor pressure solvent from the viewpoint of achieving both printability and the suppression of volume shrinkage before and after firing the conductive via precursor (for example, between step C of forming the conductive via precursor and step d of firing the conductive via precursor) to suppress voids and cracks. In this case, each of the high vapor pressure solvent and the low vapor pressure solvent may be used alone or both may be used in combination of two or more kinds thereof. The content ratio of the high vapor pressure solvent to the low vapor pressure solvent may be 20/80 to 80/20 or 30/70 to 70/30 in a mass ratio of [high vapor pressure solvent/low vapor pressure solvent].

The content of the volatile solvent in the metal paste of the present embodiment may be 2% by mass or more, 3% by mass or more, or 3.5% by mass or more, or may be 5% by mass or less, 4.8% by mass or less, 4.5% by mass or less, 4.3% by mass or less, or 4% by mass or less, or may be 2% to 5% by mass, 3% to 4.8% by mass, or 3.5% to 4.5% by mass, based on the total mass of the metal paste.

The metal paste of the present embodiment may contain a resin component such as an epoxy resin. The metal paste of the present embodiment may have a content of the resin component of 10% by mass or less, 5% by mass or less, or may be free of a resin component.

The metal paste can be prepared by mixing the above-described metal particles such as copper particles and an arbitrary component(s) (such as additives) with the above-described volatile solvent. After mixing the components, a stirring treatment may be carried out. The maximum diameter of a dispersion may be adjusted by a classification operation. In addition, means such as a three-roll mill, a kneader, or a planetary mixer can be used for mixing the respective components.

When the metal paste contains the first copper particles and the second particles described above, the second copper particles, the surface treatment agent, and the dispersion medium may be mixed in advance, and a dispersion treatment may be carried out to prepare a dispersion of the second copper particles, the first copper particles, and other metal particles as necessary, and any additives may be further mixed to complete the preparation. By adopting such a procedure, the dispersibility of the second copper particles is improved, the mixability with the first copper particles is improved, and the performance of the metal paste is further improved. The dispersion of the second copper particles may be subjected to a classification operation to remove aggregates.

The metal paste of the present embodiment may have a viscosity of 100 to 600 Pa·s or 150 to 400 Pa·s at 25°C from the viewpoint of printability. The viscosity of the metal paste is measured by using a micro spiral viscometer PCU-02V (manufactured by Malcom Co., Ltd., product name) under conditions of a rotation speed of 10 rpm and a temperature of 25°C.

### <Method for Manufacturing Substrate with Conductive Vias>

The method for manufacturing a substrate with conductive vias of the present embodiment comprises: step a of preparing a substrate provided with a hole and providing a metal paste part containing metal particles and a volatile solvent to cover at least a surface surrounding the hole of the substrate while filling an inside of the hole; step b of heating the metal paste part to remove a part of the volatile solvent; step c of removing a portion of the metal paste part after heating to expose the surface to form a conductive via precursor in the inside of the hole, the conductive via precursor comprising the metal particles and a remainder of the volatile solvent and having a planarized exposed surface; and step d of firing the conductive via precursor to form a conductive via, wherein the metal particles comprise first metal particles having a volume average particle diameter of 0.8 µm or more and second metal particles having a volume average particle diameter of 0.5 µm or less, the metal paste part provided in step a has a metal particle concentration of 95.0% by mass or more, and a content of the second metal particles in the metal paste part provided in step a is 50% by mass or less based on a total amount of the metal particles.

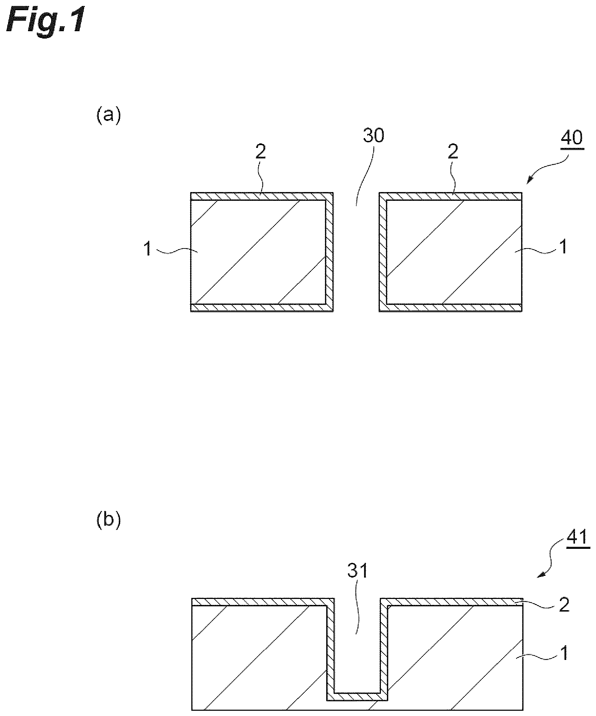

FIGS. 1 to 3 are schematic diagrams illustrating an example of the method for manufacturing a substrate with conductive vias according to the present embodiment. FIG. 1 illustrates an example of a substrate used in the method for manufacturing a substrate with conductive vias. Hereinafter, the method for manufacturing a substrate with conductive vias according to the present embodiment will be described with reference to these drawings. In the present embodiment, since the case where the metal paste contains the above-described copper particles as the metal particles is illustrated as an example, the copper particles, the copper layer, and the copper sintered body can be interpreted as the metal particles, the metal layer, and the metal sintered body, respectively.

### [Step a]

Examples of the substrate provided with a hole prepared in this step include an organic substrate, a silicon substrate, a glass substrate, a ceramic substrate, a printed wiring board, a semiconductor package substrate, and the like. The silicon substrate may be a substrate formed of polycrystalline silicon or may be a square silicon substrate formed of polycrystalline silicon. The hole may be a through-hole or a blind-hole. In the present embodiment, for example, as illustrated in FIG. 1(a), it is possible to prepare a silicon substrate 40 including a silicon wafer 1 provided with a through-hole 30 and a metal coating 2 provided on the wall surface of the through-hole and the surfaces of the silicon wafer 1. The through-hole 30 penetrates through both main surfaces of the silicon substrate 40. Although a case where a conductive via is provided in the silicon substrate 40 will be described as an example, the silicon wafer may be replaced with another insulating base in the following description.

The thickness of the silicon wafer 1 may be 100 µm or more, 200 µm or more, or 300 µm or more from the viewpoint of suppressing warpage of the substrate after sintering, or may be 800 µm or less, 300 µm or less, 200 µm or less, or 100 µm or less from the viewpoint of reducing the weight and increasing the density of the substrate. In addition, when a polycrystalline silicon substrate or the like is used, the thickness may be 0.05 to 2 mm, 0.1 mm to 1.5 mm, or 0.2 to 1 mm.

The upper limit value of the hole diameter of the through-hole 30 may be 200 µm or less, 100 µm or less, or 60 µm or less from the viewpoint of achieving a high density of a semiconductor device to be obtained, and the lower limit value of the hole diameter of the through-hole 30 is not particularly limited, but may be 10 µm or more, 20 µm or more, 30 µm or more, or 50 µm or more.

The ratio of the depth to the hole diameter of the through-hole 30 [(depth)/(hole diameter)] may be 0.5 to 40, 1 to 20, or 2 to 10.

The number of through-holes 30 provided in the silicon substrate 40 may be 100 or more, 200 or more, or 300 or more per 1 cm² of the main surface of the substrate from the viewpoint of achieving high integration of a semiconductor device to be obtained.

The metal coating 2 may be provided on both main surfaces of the silicon wafer 1 and the wall surface of the through-hole 30, may be provided on at least one main surface of the silicon wafer 1 and the wall surface of the through-hole 30, may be provided only on the wall surface of the through-hole 30, or may not be provided. In the embodiment illustrated in FIG. 1(a), the silicon substrate 40 is provided with the metal coating 2 on both main surfaces of the silicon wafer 1 and the wall surface of the through-hole 30.

Examples of the metal coating 2 include titanium, nickel, chromium, copper, aluminum, palladium, platinum, gold, and the like. From the viewpoint of adhesion, the metal coating 2 is preferably a coating with titanium, nickel, and copper layered in this order. The surface of the silicon wafer 1 is oxidized to form silicon oxide, and a titanium layer is formed on the silicon oxide, thereby improving adhesiveness. In addition, by providing a nickel layer on the titanium layer and providing a copper layer thereon, the diffusion of copper into the silicon wafer 1 can be suppressed as compared with a case where the copper layer is directly provided on the titanium layer. Furthermore, by providing a copper layer on the surface, the adhesion between the copper layer and the copper particles in the metal paste is improved, and the reliability is improved.

As illustrated in FIG. 1(b), in a case of preparing a silicon substrate 41 provided with a blind-hole 31 as a hole, a conductive via serving as a through electrode can be formed by grinding the side of the silicon substrate opposite to the surface on which the blind-hole 31 is opened, after step a, step b, step c, or step d. Examples of the grinding method include mechanical polishing, chemical mechanical polishing, and the like.

The metal paste part 3 can be provided, for example, by a method of directly applying a metal paste containing metal particles and a volatile solvent onto the silicon substrate 40, or a method of producing a film pre-coated with the metal paste and pressing the film against the substrate. In the case of the former method, examples of the method for applying or filling the metal paste include printing methods such as a screen printing method, an inkjet printing method, an intaglio printing method, a planographic printing method, an offset printing method, and a flexographic printing method, and printing methods combining these printing methods, and methods such as a spin coating method, a dip method, a roll method, a squeegee method, and a press method. Among these methods, a screen-printing method, a squeegee method for directly filling the substrate under a vacuum atmosphere, and a vacuum press method for pressing a film pre-coated with the metal paste under a vacuum atmosphere are preferred.

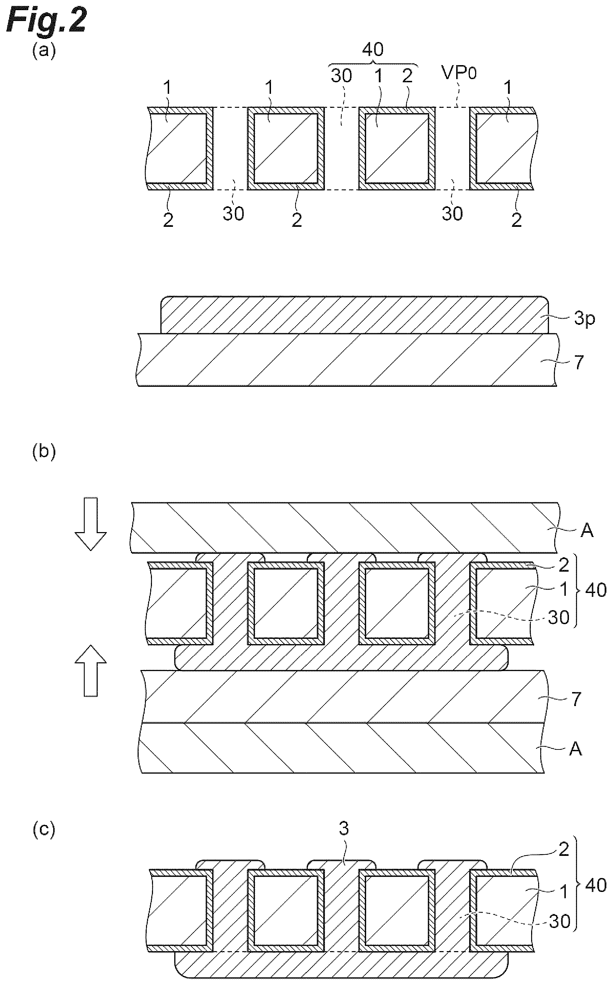

In the case of the latter method, as illustrated in FIGS. 2(a) to 2(c), the metal paste part 3 can be provided, for example, by producing a metal particle film in which a metal particle-containing layer 3p formed of the metal paste of the present embodiment described above is provided on a support film 7 and by pressing the metal particle film against the substrate.

Examples of the support film 7 include a polyimide film, a polyethylene naphthalate film, and a polyethylene terephthalate film. The thickness of the support film may be 20 to 200 µm, 25 to 175 µm, or 30 to 150 µm from the viewpoint of workability for forming the metal particle-containing layer by coating.

The composition of the metal particles and the volatile solvent in the metal particle-containing layer can be appropriately set so that the conditions in the metal paste of the present embodiment described above are satisfied. The thickness of the metal particle-containing layer may be 100 µm or less. From the viewpoint of easily ensuring sufficient fillability of through-holes or blind-holes, the thickness of the metal particle-containing layer may be 30 µm or more, 40 µm or more, or 50 µm or more.

From the viewpoint of suppressing the occurrence of voids in the through-holes or the blind-holes, the metal particle-containing layer may have an undulation (height difference) of 20 µm or less or 10 µm or less on the surface opposite to the support film. By reducing the undulation (height difference), it becomes easy to fill a large number of through-holes or blind-holes present in the base simultaneously when the metal particle film is pressed to fill the holes of the base with the metal particle composition, and it becomes easier to reduce completely unfilled through-holes or blind-holes as well as through-holes or blind-holes in which voids partially occur. The evaluation of the undulation (height difference) can be measured by a non-contact method using a laser displacement meter or the like.

The above-described metal particle film can be produced by applying the metal paste of the present embodiment described above on a support film to form a metal particle-containing layer having a concentration of metal particles of 95.0% by mass or more, or by applying a metal paste having an increased content of a volatile solvent (for example, increased to an amount such that the concentration of the metal particles is less than 94.0% by mass) and drying the coating film to form a metal particle-containing layer having a concentration of metal particles of 95.0% by mass or more.

Examples of the method for applying the metal paste include application methods using screen printing, transfer printing, offset printing, a jet printing method, a dispenser, a jet dispenser, a needle dispenser, a comma coater, a slit coater, a die coater, a gravure coater, slit coating, relief printing, intaglio printing, gravure printing, stencil printing, soft lithography, bar coating, an applicator, a particle deposition method, a spray coater, a spin coater, a dip coater, and the like.

From the viewpoint of coating workability and uniformity of the thickness of the coating film, the metal paste can be applied onto the support film by screen printing.

The thickness of the coating film may be 1 µm or more, 2 µm or more, 3 µm or more, 5 µm or more, 10 µm or more, 15 µm or more, or 20 µm or more, or may be 300 µm or less, 250 µm or less, 200 µm or less, 150 µm or less, 120 µm or less, 100 µm or less, 80 µm or less, or 50 µm or less.

The step of drying the coating film to form the metal particle-containing layer can be performed at normal temperature or a temperature of normal temperature to 100°C or lower, and the atmosphere may be in the ambient atmosphere or in nitrogen.

In step a, the above-described metal particle film is pressed against the silicon substrate 40 so that the metal particle-containing layer 3p of the metal particle film is brought into contact with the silicon substrate 40 to fill the through-hole 30 of the silicon substrate 40 with the metal paste. In this case, for example, as illustrated in FIG. 2(b), the metal particle film and the silicon substrate 40 can be sandwiched and pressurized by a pressure jig A from above and below. The pressure jig A is not particularly limited and may be a commercially available one, and may also be manufactured using a metal member having a flat part. For example, a pressure jig including two or more of the above-described metal members can press the metal particle film against the silicon substrate by sandwiching the metal particle film and the silicon substrate between the metal members arranged so that the flat portions face each other. The pressure jig A may have a mechanism that adjusts the pressure applied to the metal particle film and the silicon substrate. As the pressure adjusting means, a spring or the like can be used. In the present embodiment, a vacuum press method of performing pressing under a vacuum atmosphere may also be used.

The pressing can be carried out under the conditions of, for example, a temperature of normal temperature to 50°C or lower, and the atmosphere may be in a vacuum, in the ambient atmosphere, or in nitrogen. For the purpose of reducing voids, the metal particle film may be pressed against the silicon substrate after being held at a degree of vacuum of 1,000 Pa or less or a degree of vacuum of 200 Pa or less. The pressure of the pressure jig when pressing the metal particle film against the silicon substrate may be a pressure within a range in which the silicon wafer is not cracked, and may be, for example, 0.01 MPa or more, 0.1 MPa or more, or 1 MPa or more.

The metal paste part 3 need only cover at least the surface surrounding the hole of the substrate while filling the inside of the hole, and as illustrated in FIGS. 2(b) and 2(c), the metal paste part may protrude from an opening (VP₀ in FIG. 2(a)) of the through-hole positioned on the side of the substrate opposite to the side on which the metal particle film is pressed, to cover the surface around the hole.

### [Step b]

In this step, the metal paste part is heated to remove a part of the volatile solvent, in other words, the metal paste part is heated so that a part of the volatile solvent remains. When the above-described metal particle film is used, the metal paste part can be heated after the support film is peeled off.

The heating can be carried out, for example, by using a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, a steam heating furnace, a hot plate press device, or the like.

The atmosphere for heating may be the ambient atmosphere, may be an oxygen-free atmosphere such as nitrogen and a rare gas, or may be a reducing atmosphere such as hydrogen and formic acid. In a case of the ambient atmosphere, when the heating temperature exceeds 100°C, the copper particles are easily oxidized, but when the metal paste part contains the above-described high vapor pressure solvent as a volatile solvent, a part of the volatile solvent can be removed at a temperature of lower than 100°C, 95°C or lower, or 90°C or lower. When the metal paste part does not contain the high vapor pressure solvent as a volatile solvent, for example, contains the above-described low vapor pressure solvent alone, the oxidation of the copper particles can be suppressed while a part of the volatile solvent is removed by heating at 110°C or higher, 130°C or higher, or 150°C or higher in an oxygen-free atmosphere or a reducing atmosphere.

When the metal paste part contains the high vapor pressure solvent, the heating temperature may be 70°C or higher and lower than 100°C or may be 80°C or higher and 95°C or lower from the viewpoint of suppressing the oxidation of the copper particles, and the heating time may be 5 to 60 minutes or 10 to 30 minutes from the viewpoint of suppressing the oxidation of the copper particles.

In addition, the heating may be carried out so that the concentration of the metal particles in the metal paste part is 96% by mass or more, 97.5% by mass or more, or 98% by mass or more, from the viewpoint of suppressing volume shrinkage before and after firing the conductive via precursor (for example, between step C of forming the conductive via precursor and step d of firing the conductive via precursor) to suppress voids and cracks.

### [Step c]

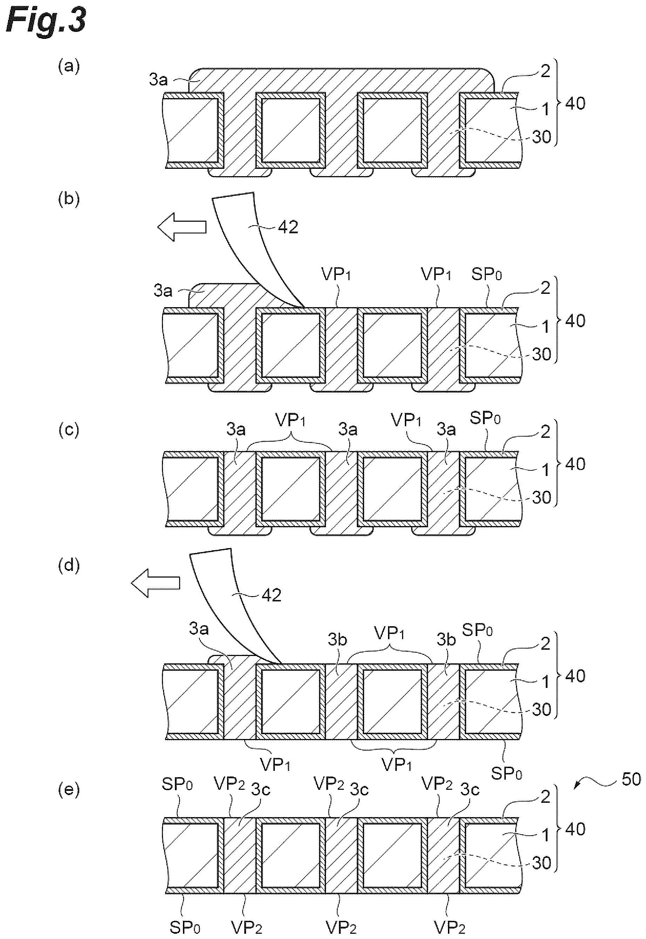

In this step, as illustrated in FIGS. 3(a) to 3(d), for the heated metal paste part 3a obtained in step b, the metal paste with which the holes are filled is planarized (or smoothed) while the metal paste that covers the surface of the substrate is removed. As a result, conductive via precursors 3b, each having a planarized exposed surface VP₁ and containing the metal particles and a remainder of the volatile solvent, can be formed inside the holes (through-holes 30) (FIG. 3(d)).

The metal paste part can be removed, for example, by using a rubber squeegee 42 as illustrated in FIGS. 3(b) and 3(d). As a result, a part of the metal paste part (the metal paste covering the surface of the substrate and the metal paste protruding from the hole) can be removed so that the surface SP₀ of the substrate 40 and the exposed surface VP₁ of the conductive via precursor 3b are flush with each other. In addition, as another method, removal with a metal squeegee such as SUS can be mentioned.

The step height between the surface SP₀ of the substrate 40 and the exposed surface VP₁ of the conductive via precursor 3b may be 5 µm or less or 3 µm or less in a direction perpendicular to the substrate surface. In addition, the average step height calculated by the following method may fall within the above-described range.

### (Average Step Height)

The average step height is calculated by acquiring an image of a cross-section passing through the center of a hole (via), binarizing the cross-section image to obtain a cross-sectional area Sa surrounded by inner walls of the hole (via), an exposed surface of a conductive via precursor, and an opening surface of the hole (via), and dividing the cross-sectional area Sa by an interval Wa between the inner walls of the hole.

### [Step d]

In this step, the conductive via precursor 3b formed in step c is fired. As a result, a conductive via 3c formed of a metal body can be formed. The metal body can contain a copper sintered body having a porous structure. The porosity of the conductive via may be 7% or less, 1.0% to 6.5%, or 1.5% to 5.0% from the viewpoint of suppressing the penetration of chemical solutions such as a resist stripping solution and a pre-plating treatment solution into the copper sintered body during immersion in a subsequent step and improving reliability. When the conductive via is formed of a copper sintered body, the porosity of the copper sintered body may fall within the above-described range. The porosity can be determined by the method described in the Examples.

The firing can be performed by heat treatment. The heat treatment can be carried out, for example, by using heating means such as a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, and a steam heating furnace.

The atmosphere during the firing may be an oxygen-free atmosphere from the viewpoint of suppressing oxidation of the copper sintered body or may be a reducing atmosphere from the viewpoint of removing the surface oxide of the copper particles in the conductive via precursor. Examples of the oxygen-free atmosphere include an atmosphere into which an oxygen-free gas such as nitrogen or a rare gas is introduced, or a vacuum atmosphere. Examples of the reducing atmosphere include a pure hydrogen gas, a mixed gas of hydrogen and nitrogen represented by a forming gas, nitrogen containing a formic acid gas, a mixed gas of hydrogen and a rare gas, and a rare gas containing a formic acid gas. When the conductive via precursor is sintered by heating without pressurization, the atmosphere may be a pure hydrogen gas or a mixed gas of hydrogen and nitrogen represented by a forming gas, and is preferably a pure hydrogen gas. The heating in the pure hydrogen gas can lead to a decrease in the sintering temperature of the copper particles. When the pure hydrogen gas is used, the gas reaches the center part of the through-hole 30 even though the thickness of the substrate is as large as 600 µm and the diameter of the through-hole 30 is as small as 10 µm, and thus it is easy to obtain a metal body containing a copper sintered body.

The maximum temperature reached during the heat treatment may be 150°C or higher, or may be 350°C or lower, 300°C or lower, or 260°C or lower from the viewpoint of reducing thermal damage to respective device members and improving the yield. As long as the maximum temperature reached is 150°C or higher, sintering tends to proceed sufficiently within a holding time of 60 minutes or less at the maximum temperature reached. The holding time at the maximum temperature reached may be 1 minute or more, or may be 60 minutes or less, 40 minutes or less, or 30 minutes or less from the viewpoint of volatilizing the entire volatile solvent and improving the yield.

In the present embodiment, by using the metal paste of the present embodiment, sintering can be performed at a low temperature of 300°C or lower, 200°C or lower, or 150°C or lower in an atmosphere containing a formic acid gas, and firing may be performed at 100°C to 300°C, 100°C to 200°C, or 100°C to 150°C. Even in this case, a conductive via having excellent conductivity and connection reliability can be formed.

The firing of the conductive via precursor may be performed without pressurization or may be performed with a pressure applied. In the latter case, under a pure hydrogen gas-containing atmosphere, the pressure may be 0.05 MPa or more, 0.1 MPa or more, or 0.3 MPa or more, or may be 20 MPa or less, 15 MPa or less, or 10 MPa or less. In addition, under a nitrogen gas-containing atmosphere, the pressure may be 1 MPa or more or 3 MPa or more, or may be 20 MPa or less, 15 MPa or less, or 10 MPa or less.

By setting the pressure to 0.05 MPa or more when the pure hydrogen gas is used and to 1 MPa or more when the nitrogen gas is used, the occurrence of voids in the conductive via formed in the center part of the through-hole 30 is easily suppressed, and a conductive via having good conductivity is easily obtained. In addition, when the silicon substrate 40 includes the metal coating 2, the bonding strength between the metal coating 2 and the conductive via is easily improved by setting the pressure to the above-described lower limit value or more.

In addition, when the pressure applied during the firing is within the above-described range, a special pressurizing device is unnecessary, and thus the reduction of voids and further improvement of the bonding strength and connection reliability can be achieved without impairing the yield. Examples of a method for applying pressure to the silicon substrate in which the conductive via precursor is formed in the through-hole include a method of placing a weight, a method of applying pressure using a pressurizing device, and a method of applying pressure using a fixing jig for applying pressure.

In the copper sintered body contained in the metal body, the ratio of the copper element among the constituent elements, excluding light elements, may be 95% by mass or more, 97% by mass or more, 98% by mass or more, or 100% by mass. When the ratio of the copper element in the copper sintered body is within the above-described range, it is possible to suppress the formation of an intermetallic compound or the precipitation of foreign elements on the grain boundaries of metal copper crystals, the properties of the metal copper constituting the copper sintered body are easily enhanced, and a more excellent connection reliability is easily obtained.

In step d, since the conductive via precursor has an exposed surface VP₁ that is planarized and has a sufficiently small step height with respect to the substrate surface, and further has a composition that is less likely to undergo volume shrinkage by firing, the step height between the surface SP₀ of the substrate 40 and the exposed surface VP₂ of the conductive via 3c can be sufficiently reduced.

The step height (or a recess of the conductive via 3c) between the surface SP₀ of the substrate 40 and the exposed surface VP₂ of the conductive via 3c may be 5 µm or less or 3 µm or less in a direction perpendicular to the substrate surface. In addition, the average step height calculated by the following method may fall within the above-described range.

### (Average Step Height)

The average step height is calculated by acquiring an image of a cross-section passing through the center of a hole (via), binarizing the cross-section image to obtain a cross-sectional area Sb surrounded by the inner walls of the hole (via), the exposed surface of the conductive via, and the opening surface of the hole (via), and dividing the cross-sectional area Sb by the interval Wb between the inner walls of the hole.

The substrate with conductive vias 50 can be obtained through the above-described steps a to d. In the substrate with conductive vias 50, since the exposed surface of the conductive via is planarized (or smoothed) and the step height with respect to the surface SP₀ of the substrate 40 is sufficiently small, it is easy to form a wiring, and a sufficiently low connection resistance value can be exhibited even after the wiring is formed.

The method for manufacturing a substrate with conductive vias according to the present embodiment can further include step e of forming a wiring. In this case, the method can be used as a method for manufacturing a wiring board with conductive vias.

### [Step e]

This step can include a resist forming step, a plating step, a resist removing step, and an etching step described below.

### <Resist Formation Step>

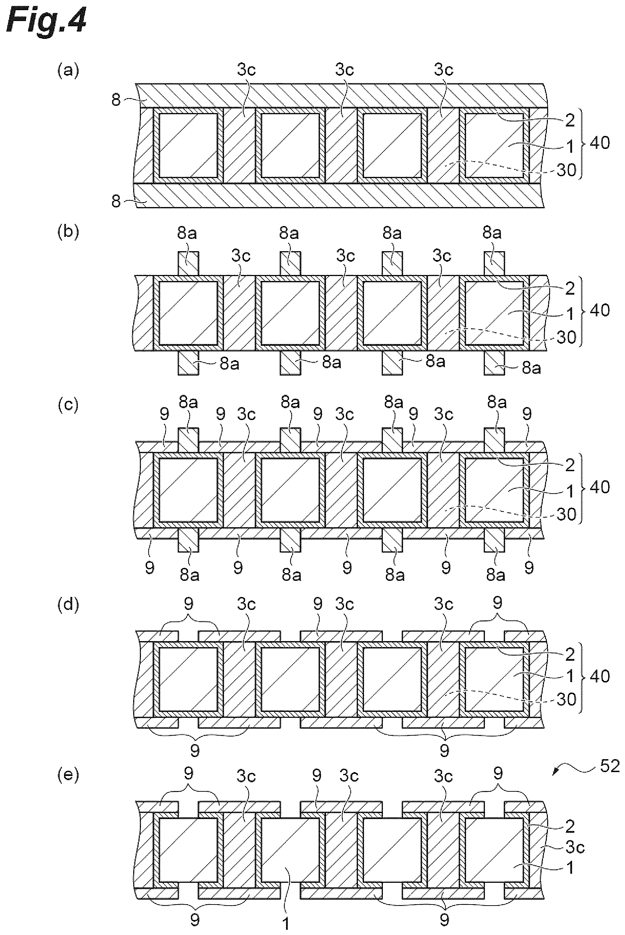

In the resist forming step, for example, as illustrated in FIGS. 4(a) and 4(b), an etching resist 8a can be formed in the following manner: a negative photosensitive dry film 8 for an etching resist is laminated on the main surface of the silicon substrate 40 and the conductive via 3c; a photomask that transmits light in a wiring shape is then superimposed; and exposure is carried out with ultraviolet rays; and unexposed portions are removed with a developer.

Examples of a method for forming the etching resist 8a other than the above-described manner include a method of silk-screen printing a resist ink and a method of bonding a dry film resist with a laminator.

### <Plating Step>

In the plating step, for example, as illustrated in FIG. 4(c), a wiring 9 can be formed in an opening of the etching resist 8a by a method such as electrolytic plating or electroless plating.

### <Resist Removing Step>

In the resist removing step, for example, as illustrated in FIG. 4(d), the etching resist 8a can be removed by a method such as peeling by a wet process using an alkaline aqueous solution or an organic solvent-based chemical solution such as an organic amine-based chemical solution such as TMAH or a ketone-based chemical solution such as acetone, or peeling by a dry process such as plasma or ozone.

### <Etching Step>

In the etching step, the metal coating 2 at a part not covered by the wiring 9 can be removed by etching. In the present embodiment, a part of the metal coating 2 provided on both main surfaces of the silicon wafer 1 is removed by etching.

Examples of the etching method include methods using a chemical etching solution used for a normal wiring board, such as a solution of cupric chloride and hydrochloric acid, a ferric chloride solution, a solution of sulfuric acid and hydrogen peroxide, or an ammonium persulfate solution.

A wiring board with conductive vias 52 as illustrated in FIG. 4(e) can be obtained through the above-described step e.

In the method described above, a step of removing at least a part of a conductor such as the sintered body of the metal paste or the metal coating 2 remaining on the main surface of the silicon substrate 40 may be provided before step e.

Examples of means for removing the conductor include chemical polishing, mechanical polishing, chemical mechanical polishing, fly cut treatment, and plasma treatment. The fly cut treatment means cutting planarization by a surface planer.

In addition, a metal coating may be further formed on the surface of the substrate with conductive vias 50 obtained through the above-described steps a to d. Examples of the metal coating include titanium, nickel, chromium, copper, aluminum, palladium, platinum, gold, and the like. From the viewpoint of adhesion and etching in subsequent steps, the metal coating is preferably copper. The metal coating can be formed by plating or sputtering, but sputtering is more preferred. In this case, in the above-described resist forming step, plating step, resist removing step, and etching step, it is possible to suppress oxidation of the copper sintered body by preventing penetration of chemical solutions into the copper sintered body having a porous structure, thereby improving reliability.

According to the method for manufacturing a substrate with conductive vias of the present embodiment, since it is possible to obtain a substrate with conductive vias in which the main surface of the substrate (such as the metal coating 2, for example) is sufficiently exposed and which has a conductive via with a sufficiently small step height with respect to the main surface of the substrate, a step of planarizing the main surface of the substrate such as the above-described step of removing the conductor can be omitted.

Furthermore, in the present embodiment, step S2 of providing a resin-containing part containing a photosensitive resin composition or a cured product thereof in the conductive via of the substrate with conductive vias obtained through the above-described steps a to d may be performed. This makes it even easier to maintain excellent connection reliability even after wiring formation. The present inventors infer that the reason such an effect is achieved is as follows. First, since the conductive via is formed by a metal sintered body having a porous structure, stress relaxation properties are obtained, and an effect of suppressing cracking of the material around the metal sintered body is easily obtained. On the other hand, a metal sintered body having a porous structure is susceptible to the adverse effects of oxidation caused by penetration of agents or the like used during wiring formation (for example, oxidation of the metal sintered body accompanying penetration of an aqueous solution). In contrast, it is considered that by providing the resin-containing part in the conductive via, the above-described adverse effects can be sufficiently reduced. In addition, it is considered that the use of the photosensitive resin composition, which allows the resin composition on the surface of the metal sintered body to be removed by the corresponding development treatment while leaving the resin composition inside the metal sintered body, is also one of the reasons why the above-described effect is obtained.

In addition, the conductive via may be provided with the above-described resin-containing part and a resin-free part not containing the resin composition or a cured product thereof, such that the resin-containing part is localized on the opening side (the exposed surface side of the conductive via). This makes it possible to prevent the adverse effects of penetration of agents and the like during wiring formation in subsequent steps while suppressing an increase in the connection resistance value caused by the resin-containing part.

The photosensitive resin composition may be any composition capable of forming a predetermined pattern by exposure and development and may be a negative type or a positive type.

Examples of a method for providing the resin-containing part containing the photosensitive resin composition in the conductive via include a method of laminating a film-shaped photosensitive resin composition or a method of applying a liquid photosensitive resin composition. In the case of providing the resin-containing part containing a cured product of the photosensitive resin composition in the conductive via, the photosensitive resin composition can be cured after providing the resin-containing part containing the photosensitive resin composition. In this case, the photosensitive resin composition may contain a thermosetting component and be capable of thermosetting.

Step S2 may include: step S2-1a of impregnating at least a part of the conductive via with the negative photosensitive resin composition by laminating a film-shaped negative photosensitive resin composition on the surface of the substrate with conductive vias; and step S2-2a of removing the film-shaped negative photosensitive resin composition by a development treatment after step S2-1a to expose the conductive via having the resin-containing part containing the negative photosensitive resin composition at the opening of the hole.

As the film-shaped negative photosensitive resin composition, dry film resists such as a photocurable dry film resist and a thermosetting dry film resist can be used, and for example, commercially available products such as RD-1619 (manufactured by Resonac Corporation, product name), HM-4035 (manufactured by Resonac Corporation, product name), HM-4056 (manufactured by Resonac Corporation, product name), TMMF NA1000 (manufactured by Tokyo Ohka Kogyo Co., Ltd., product name), and PSR-800 AUS SR-1 (manufactured by Taiyo Ink Mfg. Co., Ltd., product name) may be used.

Examples of the method for laminating the film-shaped negative photosensitive resin composition include methods using a roll laminator, a laminator, a press, and the like.

The pressure may be 0.1 MPa or more, 0.4 MPa or more, or 1 MPa or more from the viewpoint of facilitating impregnation of the conductive via with the photosensitive resin composition. The upper limit of the pressure may be 10 MPa or less from the viewpoint of reducing the influence on the substrate.

From the viewpoint of facilitating impregnation of the conductive via with the photosensitive resin composition, lamination may be performed while heating. The heating temperature is not particularly limited as long as the photosensitive resin composition does not cure, and may be 50°C to 100°C or 70°C to 90°C.

From the viewpoint of facilitating impregnation of the conductive via with the photosensitive resin composition, the film-shaped negative photosensitive resin composition may be laminated after maintaining a degree of vacuum of 1,000 Pa or less or a degree of vacuum of 200 Pa or less.

The depth with which the photosensitive resin composition is impregnated into the conductive via may be 0.2% or more, 0.5% or more, or 1% or more with respect to the total length of the conductive via in the thickness direction of the substrate from the viewpoint of connection reliability, and the distance from the exposed surface of the conductive via may be 1 µm or more, 2 µm or more, or 3 µm or more.

In step S2-2a, a development treatment corresponding to the photosensitive resin composition can be applied. As the developer, for example, an alkaline aqueous solution obtained by dissolving an alkaline compound such as sodium carbonate, sodium hydroxide, potassium hydroxide, tetramethylammonium hydroxide, or choline in water to a concentration of about 1% to 10% by mass, or an alkaline aqueous solution such as aqueous ammonia can be used. Examples of the development method include a shower development method, a spray development method, an immersion development method, and a paddle development method.

Step S2 may further include step S2-3a of curing the negative photosensitive resin composition contained in the resin-containing part after step S2-2a.

In the case of photocuring, examples of actinic rays used for exposure include: a light beam using a g-line stepper as a light source; ultraviolet rays using a low-pressure mercury lamp, a high-pressure mercury lamp, a metal halide lamp, an i-line stepper, or the like as a light source; an electron beam; and a laser beam. The exposure amount is appropriately selected depending on the light source used, the thickness of the impregnated photosensitive resin composition, and the like.

When the negative photosensitive resin composition contains a thermosetting component, thermosetting may be performed.

Step S2 may further include step S2-4a of performing a desmear treatment on at least the exposed surface of the conductive via after step S2-3a.

Examples of the desmear treatment include plasma cleaning and treatment with a desmear solution containing a permanganate and a caustic composition (for example, an alkali metal hydroxide or the like).

As another aspect, step S2 may include: step S2-1b of impregnating at least a part of the conductive via with the negative photosensitive resin composition by applying a liquid negative photosensitive resin composition on the surface of the substrate with conductive vias; and step S2-2b of removing the coating film of the liquid negative photosensitive resin composition by a development treatment after step S2-1b to expose the conductive via having the resin-containing part containing the negative photosensitive resin composition at the opening of the hole.

As the liquid negative photosensitive composition, for example, commercially available products such as PSR-4000 G24K/CA-40 G24 (manufactured by Taiyo Ink Mfg. Co., Ltd., product name), TER-20HF (manufactured by Taiyo Ink Mfg. Co., Ltd., product name), and TMMR NA1000PM (manufactured by Tokyo Ohka Kogyo Co., Ltd., product name) may be used.

Examples of the method for applying the liquid negative photosensitive composition include methods such as screen printing, transfer printing, offset printing, a jet printing method, a dispenser, a jet dispenser, a needle dispenser, a comma coater, a slit coater, a die coater, a gravure coater, slit coating, relief printing, intaglio printing, gravure printing, stencil printing, soft lithography, bar coating, an applicator, a particle deposition method, a spray coater, a spin coater, and a dip coater. From the viewpoint of coating workability and uniformity of the thickness of the coating film, the application may be performed by screen printing or spin coating.

The depth with which the photosensitive resin composition is impregnated into the conductive via and the method for developing the coating film of the liquid negative photosensitive resin composition may be the same as those in the above-described step S2-1a and step S2-2a.

In addition, after step S2-2b, step S2-3b of curing the negative photosensitive resin composition contained in the resin-containing part may be performed in the same manner as the above-described step S2-3a, and after step S2-3b, step S2-4b of performing a desmear treatment on at least the exposed surface of the conductive via may be performed in the same manner as the above-described step S2-4a.

As another aspect, step S2 may include step S2-1c of impregnating at least a part of the metal sintered body with the positive photosensitive resin composition by applying a liquid positive photosensitive resin composition on the surface of the substrate with conductive vias or by laminating a film-shaped positive photosensitive resin composition, and step S2-2c of removing the coating film of the liquid positive photosensitive resin composition or the film-shaped positive photosensitive resin composition by exposure and development treatment after step S2-1c to expose the conductive via having the resin-containing part containing the positive photosensitive resin composition at the opening of the hole.

As the positive photosensitive composition, for example, commercially available products such as AH-3000 (manufactured by Resonac Corporation, product name), AR-5100 (manufactured by Resonac Corporation, product name), and OFPR-8600 (manufactured by Tokyo Ohka Kogyo Co., Ltd., product name) may be used.

For the application of the photosensitive composition and the lamination of the photosensitive composition, the above-described methods can be used.

The depth with which the photosensitive resin composition is impregnated into the conductive via may be the same as that in the above-described step S2-1a.

The exposure in step S2-2c can be performed using, for example, a light beam using a g-line stepper as a light source; ultraviolet rays using a low-pressure mercury lamp, a high-pressure mercury lamp, a metal halide lamp, an i-line stepper, or the like as a light source; an electron beam; a laser beam; and the like. The exposure amount is appropriately selected depending on the light source used, the thickness of the impregnated photosensitive resin composition, and the like.

The method for developing the coating film of the liquid positive photosensitive resin composition and the film-shaped positive photosensitive resin composition may be the same as that in the above-described step S2-2a.

In addition, when the positive photosensitive resin composition contains a thermosetting component, step S2-3c of thermally curing the positive photosensitive resin composition contained in the resin-containing part may be performed after step S2-2c. Furthermore, after step S2-3c, step S2-4c of performing a desmear treatment on at least the exposed surface of the conductive via may be performed in the same manner as the above-described step S2-4a.

### [Examples]

Hereinafter, the present invention will be described in more detail with reference to Examples and Comparative Examples, but the present invention is not limited to the following Examples.

### [Preparation of Metal Paste]

### (Preparation Examples A to W, and Comparative Preparation Examples A to I)

The following raw materials were mixed at the ratios shown in Tables 1 to 10 using a three-roll mill to prepare metal pastes, respectively.

### <First Copper Particles>

### (Wet Copper Powder)

Spherical copper particles W1: 1050Y (manufactured by MITSUI MINING & SMELTING CO., LTD., average particle diameter (D50): 0.81 µm, spherical shape)
Spherical copper particles W2: 1100Y (manufactured by MITSUI MINING & SMELTING CO., LTD., average particle diameter (D50): 1.1 µm, spherical shape)
Spherical copper particles W3: 1200Y (manufactured by MITSUI MINING & SMELTING CO., LTD., average particle diameter (D50): 2.1 µm, spherical shape)
Spherical copper particles W4: 1300Y (manufactured by MITSUI MINING & SMELTING CO., LTD., average particle diameter (D50): 3.5 µm, spherical shape)
Flat copper particles W1: 1100YP (manufactured by MITSUI MINING & SMELTING CO., LTD., average particle diameter (D50): 1.4 µm, flat)
Flat copper particles W2: 1200YP (manufactured by MITSUI MINING & SMELTING CO., LTD., average particle diameter (D50): 3.1 µm, flat)

### (Atomized Copper Powder)

Spherical copper particles A1: MA-C02K (manufactured by MITSUI MINING & SMELTING CO., LTD., average particle diameter (D50): 1.8 µm, spherical shape)
Spherical copper particles A2: MA-C025K (manufactured by MITSUI MINING & SMELTING CO., LTD., average particle diameter (D50): 2.4 µm, spherical shape)
Spherical copper particles A3: MA-C03K (manufactured by MITSUI MINING & SMELTING CO., LTD., average particle diameter (D50): 3.4 µm, spherical shape)

### <Second Copper Particles>

Spherical copper particles W5: CH0200L1 (manufactured by MITSUI MINING & SMELTING CO., LTD., average particle diameter (D50): 200 nm, spherical shape)

### <Solder Particles>

Solder particles 1: SnBi58 solder STC-3 (manufactured by MITSUI MINING & SMELTING CO., LTD., average particle diameter (D50): 4.1 µm, spherical shape)

### <Volatile Solvent>

(High vapor pressure solvent: vapor pressure of 4 Pa or more and 30 Pa or less at 20°C)
α-Terpineol: manufactured by FUJIFILM Wako Pure Chemical Corporation, vapor pressure of 6.5 Pa at 20°C
(Low vapor pressure solvent: vapor pressure of less than 4 Pa at 20°C)
Isobornyl cyclohexanol: manufactured by NIPPON TERPENE CHEMICALS, INC., product name "Terusolve MTPH," vapor pressure of 0.004 Pa at 20°C
Diethylene glycol mono-n-butyl ether: manufactured by Showa Chemical Co., Ltd., vapor pressure of 1.3 Pa at 20°C

For the metal pastes obtained in Preparation Examples A to W and Comparative Preparation Examples A to I, the viscosity, printability, bondability, and volume resistivity of the sintered body were evaluated in accordance with the following methods.

### <Viscosity>

The viscosity of the metal pastes was measured by using a micro spiral viscometer PCU-02V (manufactured by Malcom Co., Ltd.). The measurement conditions were a rotation speed of 10 rpm and a temperature of 25°C.

### <Printability>

In <Production of Metal Particle Film> described later, when printing was carried out on a PET film having a thickness of 100 µm by a screen printer, the number of pinhole parts where the coating was not applied on the PET film side was measured. The printability was evaluated based on the number of pinhole parts according to the following criteria. Those evaluated as A to D can be determined to be good.

### (Criteria)

A: The number of pinhole parts is 0.
B: The number of pinhole parts is 1 or more and less than 3.
C: The number of pinhole parts is 3 or more and less than 5.
D: The number of pinhole parts is 5 or more and less than 10.
E: The number of pinhole parts is 10 or more and less than 20.
F: The number of pinhole parts is 20 or more.

In addition, in <Production of Metal Particle Film> described later, after the printing was carried out on the PET film having a thickness of 100 µm by the screen printer, the coating amount (g) at a size of 8-inch ⌀ was measured.

### <Bondability>

According to the following method, a bonding sample for a shear strength test was produced, and a die shear strength was measured to evaluate the bondability according to the following criteria. Those evaluated as A to C can be determined to be good.

### (Production of Bonding Sample for Shear Strength Test)

A metal paste was stencil-printed on a copper plate having a size of 25 × 20 × a thickness of 3 mm using a stainless-steel mask having a square opening of 3 × 3 mm² and a thickness of 100 µm, and a squeegee. After drying at 90°C for 10 minutes with a hot plate, the resulting product was placed in a tube furnace (manufactured by AVC Co., LTD.), and argon gas flowed at a flow rate of 1 L/min to replace air in the tube furnace with argon gas. Thereafter, the temperature was increased to 225°C over 10 minutes while hydrogen gas flowed at 300 mL/min, and a sintering treatment was carried out at 225°C for 60 minutes to sinter the metal paste. Thereafter, the resulting product was cooled while argon gas flowed at a flow rate of 0.3 L/min and taken out into air at 50°C or lower to obtain a substrate containing a metal body formed on a copper plate as a bonding sample for the shear strength test.

### (Measurement of Die Shear Strength)

For the bonding sample for a shear strength test, the die shear strength was measured with a universal bond tester (4000 series, manufactured by Dage Japan Co., Ltd.) equipped with a DS-100 load cell by pressing the metal body or the Cu plate in the horizontal direction under the measurement conditions of a measurement speed of 5 mm/min and a measurement height of 50 µm. The mean value of 10 points was calculated and used as the mean value of the bonding strength.

### (Criteria)

A: The mean value of bonding strength is 50 N or more.
B: The mean value of bonding strength is 40 N or more and less than 50 N.
C: The mean value of bonding strength is 20 N or more and less than 40 N.
D: The mean value of bonding strength is 10 N or more and less than 20 N.
E: The mean value of bonding strength is less than 10 N.

### <Measurement of Volume Resistivity>

The metal paste prepared as described above was applied onto a glass wafer having a thickness of 1 mm by using an automatic film applicator (manufactured by Allgood Corporation) such that the application thickness was about 150 µm. The coating area was about 5 cm × about 10 cm. Next, after the wafer provided with the coating film was dried at 90°C for 10 minutes with a hot plate, the wafer was placed in a tube furnace (manufactured by AVC Co., LTD.), and argon gas flowed at a flow rate of 1 L/min to replace air in the tube furnace with argon gas. Thereafter, the temperature was increased to 225°C over 10 minutes while hydrogen gas flowed at 300 mL/min, and a sintering treatment was carried out at 225°C for 60 minutes to sinter the metal paste. Thereafter, the resulting wafer was cooled while argon gas flowed at a flow rate of 0.3 L/min and taken out into air at 50°C or lower to obtain a sample with a metal body formed on the wafer.

The volume resistivity of the metal body in the above-described sample was calculated from the surface resistance value measured with a four-point probe resistivity meter (manufactured by Mitsubishi Chemical Analytech Co., Ltd., trade name: Loresta GP) and the film thickness obtained with a non-contact surface/layer cross-sectional shape measurement system (VertScan, Ryoka Systems Inc.).

**[Table 1]**

| | | | | | Preparation Example A | Preparation Example B | Preparation Example C | Preparation Example D | Preparation Example E | Preparation Example F | Preparation Example G | Preparation Example H | Preparation Example I |
|---|---|---|---|---|---|---|---|---|---|---|---|---|---|
| Composition | Copper particles | First copper particles | Wet copper powder | Spherical copper particles W1 | 30 | 45 | - | - | - | - | - | - | - |
| | | | | Spherical copper particles W2 | - | - | - | 30 | 45 | - | - | - | - |
| | | | | Spherical copper particles W3 | - | - | - | - | - | - | 30 | 45 | - |
| | | | | Spherical copper particles W4 | - | - | - | - | - | - | - | - | - |
| | | | | Flat copper particles W1 | - | - | - | - | - | - | - | - | - |
| | | | | Flat copper particles W2 | | | | | | | | | |
| | | | Atomized copper powder | Spherical copper particles A1 | 30 | - | 45 | - | - | - | - | - | - |
| | | | | Spherical copper particles A2 | - | - | - | 30 | - | 45 | 30 | - | 45 |
| | | | | Spherical copper particles A3 | - | - | - | - | - | - | - | - | - |
| | | Second copper particles | Wet copper powder | Spherical copper particles W5 | 30 | 45 | 45 | 30 | 45 | 45 | 30 | 45 | 45 |
| | Solder particles | Solder particles 1 | | | - | - | - | - | - | - | - | - | - |
| | Volatile solvent | High vapor pressure solvent | α-Terpineol (6.5Pa) | | 2 | 2 | 2 | 2 | 2 | 2 | 2 | 2 | 2 |
| | | Low vapor pressure solvent | Isobornyl cyclohexanol | | - | - | - | - | - | - | - | - | - |
| | | | Diethylene glycol mono-n-butyl ether | | 2 | 2 | 2 | 2 | 2 | 2 | 2 | 2 | 2 |
| Content of metal particles in metal paste (% by mass) | | | | | 95.7 | 95.7 | 95.7 | 95.7 | 95.7 | 95.7 | 95.7 | 95.7 | 95.7 |
| Properties | Viscosity (Pa·s@25°C) | | | | 200 | 230 | 210 | 190 | 220 | 200 | 180 | 200 | 190 |
| | Printability | Criteria | | | A | A | A | A | A | A | A | A | A |
| | | Coating amount (g) | | | 4.7 | 4.9 | 4.8 | 4.7 | 5.1 | 5 | 4.6 | 5 | 5 |
| | Bondability | Bonding strength with Cu (N) | | | 67 | 63 | 42 | 65 | 61 | 45 | 58 | 62 | 46 |
| | | Criteria | | | A | A | B | A | A | B | A | A | B |
| | Volume resistivity (µΩ·cm) | | | | 3.5 | 3.3 | 3.9 | 3.7 | 3.5 | 4.1 | 4 | 3.7 | 4.2 |

**[Table 2]**

| | | | | | Preparation Example J | Preparation Example K | Preparation Example L | Preparation Example M | Preparation Example N | Preparation Example O | Preparation Example P | Preparation Example Q | Preparation Example R |
|---|---|---|---|---|---|---|---|---|---|---|---|---|---|
| Composition | Copper particles | First copper particles | Wet copper powder | Spherical copper particles W1 | - | - | - | - | - | - | - | 20 | - |
| | | | | Spherical copper particles W2 | - | - | - | - | - | - | - | - | - |
| | | | | Spherical copper particles W3 | - | - | - | - | - | - | - | 20 | - |
| | | | | Spherical copper particles W4 | 30 | 45 | - | - | - | - | - | 20 | - |
| | | | | Flat copper particles W1 | - | - | - | 30 | 45 | - | - | - | - |
| | | | | Flat copper particles W2 | | - | - | - | - | 30 | 45 | - | - |
| | | | Atomized copper powder | Spherical copper particles A1 | - | - | - | - | - | - | - | - | 20 |
| | | | | Spherical copper particles A2 | - | - | - | 30 | - | 30 | - | - | 20 |
| | | | | Spherical copper particles A3 | 30 | - | 45 | - | - | - | - | - | 20 |
| | | Second copper particles | Wet copper powder | Spherical copper particles W5 | 30 | 45 | 45 | 30 | 45 | 30 | 45 | 30 | 30 |
| | Solder particles | Solder particles 1 | | | - | - | - | - | - | - | - | - | - |
| | Volatile solvent | High vapor pressure solvent | α-Terpineol (6.5Pa) | | 2 | 2 | 2 | 2 | 2 | 2 | 2 | 2 | 2 |
| | | Low vapor pressure solvent | Isobornyl cyclohexanol | | - | - | - | - | - | - | - | - | - |
| | | | Diethylene glycol mono-n-butyl ether | | 2 | 2 | 2 | 2 | 2 | 2 | 2 | 2 | 2 |
| Content of metal particles in metal paste (% by mass) | | | | | 95.7 | 95.7 | 95.7 | 95.7 | 95.7 | 95.7 | 95.7 | 95.7 | 95.7 |
| Properties | Viscosity (Pa·s@25°C) | | | | 170 | 190 | 180 | 350 | 480 | 320 | 445 | 450 | 210 |
| | Printability | Criteria | | | A | A | A | A | A | A | A | C | A |
| | | Coating amount (g) | | | 4.4 | 5 | 5 | 6.3 | 9.1 | 5.9 | 8.7 | 7 | 4.4 |
| | | | Bondability | Bonding strength with Cu (N) | 64 | 61 | 45 | 72 | 70 | 68 | 74 | 65 | 30 |
| | | | | Criteria | A | A | B | A | A | A | A | A | C |
| | | | Volume resistivity (µΩ·cm) | | 4 | 3.7 | 4.2 | 4.2 | 4 | 4.2 | 4 | 3.1 | 4.5 |

**[Table 3]**

| | | | | | Preparation Example S | Preparation Example T | Preparation Example U | Preparation Example V | Preparation Example W |
|---|---|---|---|---|---|---|---|---|---|
| Composition | Copper particles | First copper particles | Wet copper powder | Spherical copper particles W1 | 30 | 30 | 30 | - | - |
| | | | | Spherical copper particles W2 | - | - | - | 20 | - |
| | | | | Spherical copper particles W3 | - | - | - | - | - |
| | | | | Spherical copper particles W4 | - | - | - | - | 20 |
| | | | | Flat copper particles W1 | - | - | - | 20 | - |
| | | | | Flat copper particles W2 | - | - | - | - | 20 |
| | | | Atomized copper powder | Spherical copper particles A1 | 30 | 30 | 30 | - | - |
| | | | | Spherical copper particles A2 | - | - | - | 20 | 20 |
| | | | | Spherical copper particles A3 | | | | | |
| | | Second copper particles | Wet copper powder | Spherical copper particles W5 | 30 | 30 | 30 | 30 | 30 |
| | Solder particles | Solder particles 1 | | | - | - | - | - | - |
| | Volatile solvent | High vapor pressure solvent | α-Terpineol (6.5Pa) | | 2.3 | 2.2 | 1.8 | 2 | 2 |
| | | Low vapor pressure solvent | Isobornyl cyclohexanol | | - | - | - | - | - |
| | | | Diethylene glycol mono-n-butyl ether | | 2.3 | 2.2 | 1.8 | 2 | 2 |
| Content of metal particles in metal paste (% by mass) | | | | | 95.1 | 95.3 | 96.2 | 95.7 | 95.7 |
| Properties | Viscosity (Pa·s@25°C) | | | | 150 | 165 | 250 | 250 | 230 |
| | Printability | Criteria | | | A | A | A | A | A |
| | | Coating amount (g) | | | 4.1 | 4.5 | 5.9 | 6.2 | 5.5 |
| | Bondability | Bonding strength with Cu (N) | | | 68 | 70 | 72 | 70 | 70 |
| | | | | Criteria | A | A | A | A | A |
| | | | Volume resistivity (µΩ·cm) | | 3.5 | 3.5 | 3.5 | 3.8 | 3.8 |

**[Table 4]**

| | | | | | Comparative Preparation Example A | Comparative Preparation Example B | Comparative Preparation Example C | Comparative Preparation Example D | Comparative Preparation Example E | Comparative Preparation Example F | Comparative Preparation Example G | Comparative Preparation Example H | Comparative Preparation Example I |
|---|---|---|---|---|---|---|---|---|---|---|---|---|---|
| Composition | Copper particles | First copper particles | Wet copper powder | Spherical copper particles W1 | 30 | 30 | 30 | - | - | - | - | - | 30 |
| | | | | Spherical copper particles W2 | - | - | - | 20 | 20 | 20 | - | - | - |
| | | | | Spherical copper particles W3 | - | - | - | - | - | - | - | - | - |
| | | | | Spherical copper particles W4 | - | - | - | - | - | - | - | - | - |
| | | | | Flat copper particles W1 | - | - | - | 20 | 20 | 20 | 30 | - | - |
| | | | | Flat copper particles W2 | - | - | - | - | - | - | - | 30 | - |
| | | | Atomized copper powder | Spherical copper particles A1 | - | - | - | - | - | - | - | - | 30 |
| | | | | Spherical copper particles A2 | 30 | 30 | 30 | 20 | 20 | 20 | - | - | - |
| | | | | Spherical copper particles A3 | - | - | - | - | - | - | - | - | - |
| | | Second copper particles | Wet copper powder | Spherical copper particles W5 | 30 | 30 | 30 | 30 | 30 | 30 | 70 | 70 | 30 |
| | Solder particles | Solder particles 1 | | | 5 | 3 | 1 | 5 | 3 | 1 | - | - | - |
| | Volatile solvent | High vapor pressure solvent | α-Terpineol (6.5Pa) | | 1 | 0.95 | 0.9 | 2.1 | 2.1 | 2.1 | - | - | 2.5 |
| | | Low vapor pressure solvent | Isobornyl cyclohexanol | | 4 | 3.8 | 3.6 | - | - | - | - | - | - |
| | | | Diethylene glycol mono-n-butyl ether | | - | - | - | 2.1 | 2.1 | 2.1 | 5 | 5 | 2.5 |
| Content of metal particles in metal paste (% by mass) | | | | | 95 | 95.1 | 95.3 | 95.8 | 95.7 | 95.6 | 95.2 | 95.2 | 94.7 |
| Properties | Viscosity (Pa·s@25°C) | | | | 150 | 155 | 165 | 230 | 230 | 230 | 570 | 550 | 135 |
| | Printability | Criteria | | | A | A | A | A | A | A | E | D | A |
| | | Coating amount (g) | | | 3.9 | 4.2 | 4.4 | 5.2 | 5.1 | 5.5 | 13.5 | 13.1 | 3.9 |
| | Bondability | Bonding strength with Cu (N) | | | 68 | 65 | 67 | 65 | 64 | 67 | 57 | 56 | 65 |
| | | Criteria | | | A | A | A | A | A | A | A | A | A |
| | Volume resistivity (µΩ·cm) | | | | 8.3 | 6.7 | 5.3 | 8.2 | 7.1 | 5.1 | 3.5 | 3.5 | 3.5 |

### [Production of Silicon Substrate with Conductive Vias]

### (Examples 1 to 87 and Comparative Examples 1 to 11)

Silicon substrates with conductive vias were produced by the following procedure.

### <Preparation of Silicon Substrate>

A silicon substrate provided with through-holes and including a titanium layer, a nickel layer, and a copper layer layered in this order on both main surfaces and on wall surfaces of the through-holes was prepared. The silicon substrate has a diameter of 6 inches and a thickness of 300 µm, the titanium layer, the nickel layer, and the copper layer are sequentially formed by sputtering, and through-holes having the hole diameter (via diameter) shown in the tables are provided.

### <Production of Metal Particle Film>

The metal paste prepared as described above was printed on a PET film having a thickness of 100 µm with a screen printer in a size of 8-inch ⌀ (circular shape with a diameter of 20 cm) using a screen printing plate (wire diameter: 23 µm, the number of meshes: 400, mesh size: 41 µm, and space ratio: 41 µm) to obtain a metal particle film provided with a metal particle-containing layer.

### <Formation of Conductive Via>

The metal particle film was bonded to the silicon substrate from the metal particle-containing layer side with a bonding device VJ-35 (manufactured by Ayumi Industry Co., Ltd.), and the resulting laminate was further vacuum-pressed at room temperature at a pressure of 3 MPa to fill the through-holes with the metal paste. At this time, the metal paste was protruded from the side of the silicon substrate opposite to the side on which the metal particle film was bonded.

Subsequently, the laminate from which the PET film was peeled off was dried in the ambient atmosphere at 90°C for 10 minutes. The concentration (% by mass) of the metal particles in the metal paste part before and after drying is shown in the tables.

For the dried laminate, as illustrated in FIGS. 3(a) to 3(d), the metal paste on the main surface of the silicon substrate on the side on which the metal particle film was bonded was removed using a rubber squeegee, and subsequently, the metal paste protruding from the side of the silicon substrate opposite to the side on which the metal particle film was bonded was removed using the rubber squeegee.

Subsequently, the silicon substrate having conductive via precursors formed in the through-holes by the above-described steps was placed in a tube furnace (manufactured by AVC Co., LTD.), and argon gas flowed at a flow rate of 1 L/min to replace air in the tube furnace with argon gas. Thereafter, the temperature was increased to 300°C over 10 minutes while hydrogen gas flowed at 300 mL/min, and a sintering treatment was carried out at 300°C for 60 minutes to sinter the conductive via precursors. Thereafter, the resulting substrate was cooled while argon gas flowed at a flow rate of 0.3 L/min and taken out into air at 50°C or lower to obtain a silicon substrate with conductive vias. In Examples 70 to 87, the temperature was increased to the temperature described in the tables over 10 minutes while allowing a gas to flow and maintaining the formic acid vapor concentration at 3.0% by volume (the remainder being nitrogen), and a sintering treatment was carried out under the following conditions to sinter the conductive via precursors.
Examples 70 to 72: 350°C/4 minutes
Examples 73 to 75: 300°C/6 minutes
Examples 76 to 78: 250°C/10 minutes
Examples 79 to 81: 200°C/30 minutes
Examples 82 to 84: 150°C/60 minutes
Examples 85 to 87: 120°C/60 minutes

### <Evaluation of Silicon Substrates with Conductive Vias>

For the silicon substrates with conductive vias obtained as described above, the presence or absence of cracks and voids in the conductive vias, the porosity of the conductive vias, and the recesses after sintering were evaluated in accordance with the following methods.

### (Presence or Absence of Cracks in Conductive Vias)

The cross-section of the substrate with conductive vias was exposed by cross-section polishing, and 30 conductive vias were observed with a digital microscope (manufactured by KEYENCE CORPORATION, trade name: VHX-6000) to determine the presence or absence of cracks (a length of 10 µm or more).

### (Presence or Absence of Voids in Conductive Vias)

The cross-section of the conductive vias of the silicon substrate with conductive vias was exposed by cross-section polishing, and 30 conductive vias were observed with a digital microscope (manufactured by KEYENCE CORPORATION, trade name: VHX-6000) to determine the presence or absence of voids (a diameter of 5 µm or more).

### (Recess after Sintering)

The cross-section of the conductive vias of the silicon substrate with conductive vias was exposed by cross-section polishing, and 30 conductive vias were observed with a digital microscope (manufactured by KEYENCE CORPORATION, trade name: VHX-6000), and the average step height was calculated by the following method.

### [Average Step Height]

The average step height (= Sb/Wb) was calculated by acquiring an image of a cross-section passing through the center of a via, binarizing the cross-section image to obtain a cross-sectional area Sb surrounded by inner walls of the via, the exposed surface of the conductive via, and the opening surface of the via, and dividing the cross-sectional area Sb by the interval Wb between the inner walls of the hole.

The mean value of the average step heights at 30 points was calculated, and the recess(es) after sintering was evaluated according to the following criteria. Those evaluated as C or above can be determined to be good.

### (Criteria)

A: The mean value of average step heights is less than 1 µm.
B: The mean value of average step heights is 1 µm or more and less than 3 µm.
C: The mean value of average step heights is 3 µm or more and less than 5 µm.
D: The mean value of average step heights is 5 µm or more and less than 10 µm.
E: The mean value of average step heights is 10 µm or more.

### (Porosity of Conductive Via)

The silicon substrate with conductive vias subjected to mechanical polishing was cut in the thickness direction, and the cross-section of the center part of the conductive via of the silicon substrate was exposed by a focused ion beam, and the cross-section was observed. When observing the cross-section of the center part of the through-hole of the silicon substrate, a range of ±5 µm in the thickness direction of the silicon substrate and ±5 µm in the direction perpendicular to the thickness direction of the silicon substrate from the center part of the through-hole was observed. A focused ion beam machining observation device (manufactured by Hitachi High-Tech Corporation, trade name: MI4050) was used. For the observation, a scanning electron microscope (manufactured by Hitachi High-Tech Corporation, trade name: S-3700N) was used at a magnification of 5,000 times, and a cross-section image (approximately 10 µm square) of the conductor was taken. The number of observation points was 5. The obtained cross-section images were binarized using image analysis software (Adobe Photoshop (registered trademark) Elements) so that the sintered copper part and the porous (void) part were separated. For each of the 5 observation points, the ratio of the area of the porous (void) part to the total area of the cross-section of the conductive via was determined, and this was taken as the porosity. The mean value of the porosities at the 5 observation points was taken as the porosity of the conductive via.

### <Evaluation of Wiring Board>

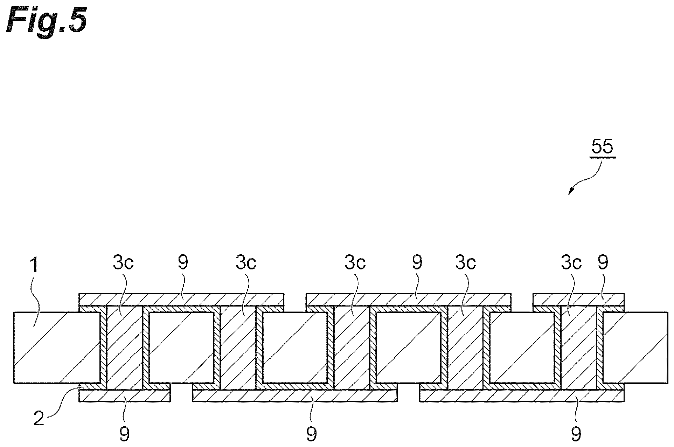

A dry film H-W425 (manufactured by Resonac Corporation, trade name) for an ultraviolet curable etching resist was pressure-bonded to the surface of the conductive via-containing silicon substrate obtained as described above with a laminator. Thereafter, a photomask was aligned to expose a wiring pattern, and resist development was carried out. Next, electrolytic plating was carried out on the openings of the resist and peeling of the resist and etching of the seed layer were then carried out to form a wiring having a wiring pattern of 300 µm × 600 µm, thereby obtaining a test piece 55 (wiring board) as illustrated in FIG. 5. In the test piece 55, the conductive vias formed in the through-holes are electrically connected by the wiring provided on the substrate surface.

For the test piece obtained as described above, the initial resistance value, the connection reliability, the presence or absence of cracking in the substrate, and the recess of the conductive vias after resist peeling were evaluated in accordance with the following methods.

### (Initial Resistance Value)

As the initial resistance value of the test piece 55, a resistance value of a predetermined number of interconnected vias was measured. The number of vias is set as follows depending on the via diameter. The initial resistance value was evaluated based on this connection resistance value according to the following criteria. Those evaluated as B or above can be determined to be good.

### (Number of Vias)

30 µm⌀: 30
50 µm⌀: 25
100 µm⌀: 20
(Criteria)
A: The resistance value is less than 10 mΩ.
B: The resistance value is 10 mΩ or more and less than 30 mΩ.
C: The resistance value is 30 mΩ or more and less than 100 mΩ.
D: The resistance value is 100 mΩ or more and less than 500 mΩ.
E: The resistance value is 500 mΩ or more.

### (Connection Reliability)

The test piece 55 was set in a temperature cycle tester (TSA-72SE-W, manufactured by ESPEC CORP.), and a temperature cycle connection reliability test was carried out under the conditions of low temperature side: -55°C, 15 minutes, room temperature: 2 minutes, high temperature side: 125°C, 15 minutes, defrosting cycle: automatic, and the number of cycles: 50, 100, 300, 500, and 1,000 cycles. For the test piece after undergoing each of the number of cycles, a resistance value of the above-described number of interconnected vias set according to the via diameter was measured. The connection reliability was evaluated based on this connection resistance value according to the following criteria.

### (Criteria)

A: The resistance change rate is less than 1% with respect to the initial resistance value.
B: The resistance change rate is 1% or more and less than 3% with respect to the initial resistance value.
C: The resistance change rate is 3% or more and less than 5% with respect to the initial resistance value.
D: The resistance change rate is 5% or more and less than 10% with respect to the initial resistance value.
E: The resistance change rate is 10% or more and less than 20% with respect to the initial resistance value.
F: The resistance change rate is 20% or more with respect to the initial resistance value.

### (Cracking of Substrate)

The test piece 55 was visually confirmed, and the presence or absence of cracking of the silicon substrate was confirmed.

### (Recess after Resist Peeling)

As for the production of the test piece 55, after resist peeling, the cross-section of the conductive vias was exposed by cross-section polishing, and 30 conductive vias were observed with a digital microscope (manufactured by KEYENCE CORPORATION, trade name: VHX-6000) to calculate the mean value of the average step heights by the same method as for evaluating the recess(es) after sintering. Then, the recess(es) after resist peeling was evaluated according to the following criteria. Those evaluated as C or above can be determined to be good.

### (Criteria)

A: The mean value of average step heights is less than 1 µm.
B: The mean value of average step heights is 1 µm or more and less than 3 µm.
C: The mean value of average step heights is 3 µm or more and less than 5 µm.
D: The mean value of average step heights is 5 µm or more and less than 10 µm.
E: the mean value of average step heights is 10 µm or more.

### [Observation and Consideration of Conductive Vias]

### (Observation 1)

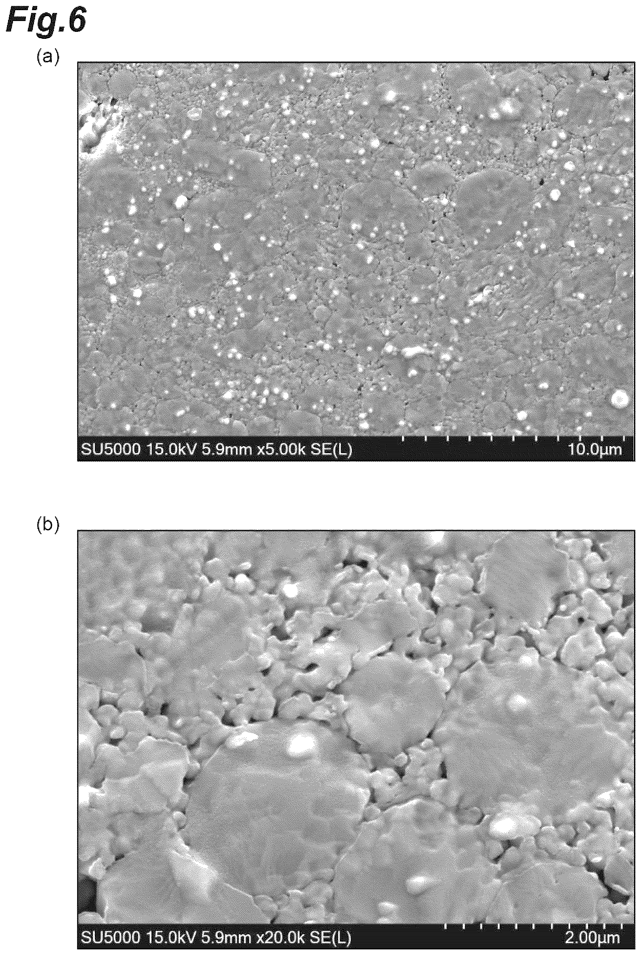

For the silicon substrate with conductive vias produced in Example 1, the cross-section of the center part of the conductive via of the silicon substrate with conductive vias was exposed by a focused ion beam using a focused ion beam machining observation device (manufactured by Hitachi High-Tech Corporation, trade name: MI4050), and the cross-section was observed. For the observation, cross-section images of the copper sintered body were imaged using a scanning electron microscope (manufactured by Hitachi High-Tech Corporation, trade name: S-3700N) at magnifications of 5,000 times and 20,000 times (see FIG. 6). The images shown in FIG. 6 are an image at a magnification of 5,000 times in (a) and an image at a magnification of 20,000 times in (b). As illustrated in FIG. 6(b), the copper sintered body has a structure in which the first copper particles are filled between the second copper particles and the particles are bonded to each other. It is considered that the formation of such a dense copper sintered body and the suppression of shrinkage during sintering to suppress the occurrence of voids and cracks and suppress recesses enabled a sufficiently low connection resistance value to be exhibited even after wiring formation, and the resulting wiring board to have excellent connection reliability.

### (Observation 2)

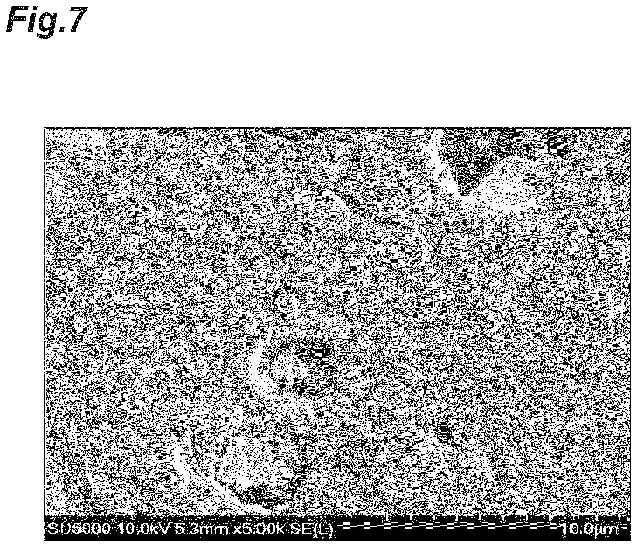

For the substrate with conductive vias produced in Comparative Example 1, cross-section images of the copper sintered body were imaged in the same manner as in Observation 1 (see FIG. 7). The image shown in FIG. 7 is an image at a magnification of 5,000 times. As illustrated in FIG. 7, the conductive via contains the copper sintered body, solder, and voids generated around the solder. It is considered that when a large number of such voids are formed in a large volume, the connection reliability of the resulting wiring board, particularly the connection reliability when subjected to large temperature changes, decreases due to the ease of penetration of the etching solution during wiring formation and the presence of the voids themselves.

**[Table 5]**

| | | | Example 1 | Example 2 | Example 3 | Example 4 | Example 5 | Example 6 | Example 7 | Example 8 | Example 9 |
|---|---|---|---|---|---|---|---|---|---|---|---|
| Metal Paste | | | Preparation Example A | Preparation Example A | Preparation Example A | Preparation Example B | Preparation Example B | Preparation Example B | Preparation Example C | Preparation Example C | Preparation Example C |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 50 | 100 | 30 | 50 | 100 | 30 | 50 | 100 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ | 100% H₂ |
| Concentration of metal particles in metal paste part (% by mass) | | Before drying (step a) | 95.7 | 95.7 | 95.7 | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 0.6 | 0.6 | 0.6 | 1.3 | 1.3 | 1.3 | 1.5 | 1.5 | 1.5 |
| | | Criteria | A | A | A | B | B | B | B | B | B |
| | Recess after resist peeling | (µm) | 0.8 | 0.8 | 0.8 | 1.6 | 1.6 | 1.6 | 1.8 | 1.8 | 1.8 |
| | | Criteria | A | A | A | B | B | B | B | B | B |
| | Porosity (%) | | 3 | 3 | 3 | 5 | 5 | 5 | 4 | 4 | 4 |
| Wiring board | Initial resistance value | | A | A | A | A | A | A | A | A | A |
| | After reliability test | 50 cycles | A | A | A | A | A | A | A | A | A |
| | | 100 cycles | A | A | B | A | A | B | A | A | B |
| | | 300 cycles | A | B | B | A | B | B | A | B | C |
| | | 500 cycles | A | B | C | B | B | C | B | B | C |
| | | 1000 cycles | A | C | C | B | C | C | B | C | C |
| | Cracking in substrate | | Absence | Absence | Absence | Absence | Absence | Absence | Absence | Absence | Absence |

**[Table 6]**

| | | | Example 10 | Example 11 | Example 12 | Example 13 | Example 14 | Example 15 | Example 16 | Example 17 | Example 18 |
|---|---|---|---|---|---|---|---|---|---|---|---|
| Metal Paste | | | Preparation Example D | Preparation Example D | Preparation Example D | Preparation Example E | Preparation Example E | Preparation Example E | Preparation Example F | Preparation Example F | Preparation Example F |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | hole 30 | 50 | 100 | 30 | 50 | 100 | 30 | 50 | 100 |
| | | Via (µm) | 300 | 300 | 300 | 300 | 300 | 300 | 300 | 300 | 300 |
| Step a | | Via depth (µm) Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ | 100% H₂ |
| Concentration of metal particles in metal paste part (% by mass) | | Before drying (step a) | 95.7 | 95.7 | 95.7 | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 0.9 | 0.9 | 0.9 | 1.5 | 1.5 | 1.5 | 2.5 | 2.5 | 2.5 |
| | | Criteria | A | A | A | B | B | B | B | B | B |
| | Recess after resist peeling | (µm) | 1.2 | 1.2 | 1.2 | 2.3 | 2.3 | 2.3 | 2.8 | 2.8 | 2.8 |
| | | Criteria | B | B | B | B | B | B | B | B | B |
| | Porosity (%) | | 3 | 3 | 3 | 5 | 5 | 5 | 4 | 4 | 4 |
| Wiring board | Initial resistance value | | A | A | A | A | A | A | A | A | A |
| | After reliability test | 50 cycles | A | A | A | A | A | A | A | A | A |
| | | 100 cycles | A | A | B | A | A | B | A | A | B |
| | | 300 cycles | A | B | B | A | B | B | A | B | B |
| | | 500 cycles | A | B | B | B | B | C | B | B | C |
| | | 1000 cycles | A | B | C | B | C | C | B | C | C |
| | Cracking in substrate | | Absence | Absence | Absence | Absence | Absence | Absence | Absence | Absence | Absence |

**[Table 7]**

| | | | Example 19 | Example 20 | Example 21 | Example 22 | Example 23 | Example 24 | Example 25 | Example 26 | Example 27 |
|---|---|---|---|---|---|---|---|---|---|---|---|
| Metal Paste | | | Preparation Example G | Preparation Example G | Preparation Example G | Preparation Example H | Preparation Example H | Preparation Example H | Preparation Example I | Preparation Example I | Preparation Example I |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 50 | 100 | 30 | 50 | 100 | 30 | 50 | 100 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ | 100% H₂ |
| Concentration of metal particles in metal paste part (% by mass) | | Before drying (step a) | 95.7 | 95.7 | 95.7 | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 0.8 | 0.8 | 0.8 | 1.7 | 1.7 | 1.7 | 1.9 | 1.9 | 1.9 |
| | | Criteria | A | A | A | B | B | B | B | B | B |
| | Recess after resist peeling | (µm) | 1.2 | 1.2 | 1.2 | 2.3 | 2.3 | 2.3 | 2.7 | 2.7 | 2.7 |
| | | Criteria | B | B | B | B | B | B | B | B | B |
| | Porosity (%) | | 3 | 3 | 3 | 5 | 5 | 5 | 4 | 4 | 4 |
| Wiring board | Initial resistance value | | A | A | A | A | A | A | A | A | A |
| | After reliability test | 50 cycles | A | A | A | A | A | A | A | A | A |
| | | 100 cycles | A | A | B | A | A | B | A | A | B |
| | | 300 cycles | A | B | B | A | B | B | A | B | B |
| | | 500 cycles | A | B | B | B | B | C | B | B | C |
| | | 1000 cycles | A | B | B | B | C | C | B | C | C |
| | Cracking in substrate | | Absence | Absence | Absence | Absence | Absence | Absence | Absence | Absence | Absence |

**[Table 8]**

| | | | Example 28 | Example 29 | Example 30 | Example 31 | Example 32 | Example 33 | Example 34 | Example 35 | Example 36 |
|---|---|---|---|---|---|---|---|---|---|---|---|
| Metal Paste | | | Preparation Example J | Preparation Example J | Preparation Example J | Preparation Example K | Preparation Example K | Preparation Example K | Preparation Example L | Preparation Example L | Preparation Example L |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 50 | 100 | 30 | 50 | 100 | 30 | 50 | 100 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ | 100% H₂ |
| Concentration of metal particles in metal paste part (% by mass) | | Before drying (step a) | 95.7 | 95.7 | 95.7 | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 1.3 | 1.3 | 1.3 | 1.8 | 1.8 | 1.8 | 2.1 | 2.1 | 2.1 |
| | | Criteria | B | B | B | B | B | B | B | B | B |
| | Recess after resist peeling | (µm) | 1.5 | 1.5 | 1.5 | 2.4 | 2.4 | 2.4 | 2.8 | 2.8 | 2.8 |
| | | Criteria | B | B | B | B | B | B | B | B | B |
| | Porosity (%) | | 4 | 4 | 4 | 6 | 6 | 6 | 5 | 5 | 5 |
| Wiring board | Initial resistance value | | A | A | A | A | A | A | A | A | A |
| | After reliability test | 50 cycles | A | A | A | A | A | A | A | A | A |
| | | 100 cycles | A | A | A | A | A | B | A | A | B |
| | | 300 cycles | A | A | B | A | B | B | A | B | B |
| | | 500 cycles | A | B | B | B | B | B | B | B | B |
| | | 1000 cycles | A | B | B | B | B | C | B | B | C |
| | Cracking in substrate | | Absence | Absence | Absence | Absence | Absence | Absence | Absence | Absence | Absence |

**[Table 9]**

| | | | Example 37 | Example 38 | Example 39 | Example 40 | Example 41 | Example 42 | Example 43 | Example 44 | Example 45 |
|---|---|---|---|---|---|---|---|---|---|---|---|
| Metal Paste | | | Preparation Example M | Preparation Example M | Preparation Example M | Preparation Example N | Preparation Example N | Preparation Example N | Preparation Example O | Preparation Example O | Preparation Example O |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 50 | 100 | 30 | 50 | 100 | 30 | 50 | 100 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ | 100% H₂ |
| Concentration of metal particles in metal paste part (% by mass) | | Before drying (step a) | 95.7 | 95.7 | 95.7 | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 3.2 | 3.2 | 3.2 | 3.3 | 3.3 | 3.3 | 3.5 | 3.5 | 3.5 |
| | | Criteria | C | C | C | C | C | C | C | C | C |
| | Recess after resist peeling | (µm) | 3.7 | 3.7 | 3.7 | 3.9 | 3.9 | 3.9 | 4.1 | 4.1 | 4.1 |
| | | Criteria | C | C | C | C | C | C | C | C | C |
| | Porosity (%) | | 5 | 5 | 5 | 6 | 6 | 6 | 6 | 6 | 6 |
| Wiring board | Initial resistance value | | A | A | A | A | A | A | A | A | A |
| | After reliability test | 50 cycles | A | A | A | A | A | A | A | A | A |
| | | 100 cycles | A | A | B | A | A | B | A | A | B |
| | | 300 cycles | A | B | B | A | B | B | A | B | B |
| | | 500 cycles | B | B | C | B | B | C | B | B | C |
| | | 1000 cycles | B | C | C | B | C | C | B | C | C |
| | Cracking in substrate | | Absence | Absence | Absence | Absence | Absence | Absence | Absence | Absence | Absence |

**[Table 10]**

| | | | Example 46 | Example 47 | Example 48 | Example 49 | Example 50 | Example 51 | Example 52 | Example 53 | Example 54 |
|---|---|---|---|---|---|---|---|---|---|---|---|
| Metal Paste | | | Preparation Example P | Preparation Example P | Preparation Example P | Preparation Example Q | Preparation Example Q | Preparation Example Q | Preparation Example R | Preparation Example R | Preparation Example R |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 50 | 100 | 30 | 50 | 100 | 30 | 50 | 100 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ | 100% H₂ |
| Concentration of metal particles in metal paste part (% by mass) | | Before drying (step a) | 95.7 | 95.7 | 95.₇ | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 3.6 | 3.6 | 3.6 | 2.5 | 2.5 | 2.5 | 2.6 | 2.6 | 2.6 |
| | | Criteria | C | C | C | B | B | B | B | B | B |
| | Recess after resist peeling | (µm) | 4.5 | 4.5 | 4.5 | 3.5 | 3.5 | 3.5 | 3.4 | 3.4 | 3.4 |
| | | Criteria | C | C | C | C | C | C | C | C | C |
| | Porosity (%) | | 7 | 7 | 7 | 4 | 4 | 4 | 3 | 3 | 3 |
| Wiring board | Initial resistance value | | A | A | A | A | A | A | A | A | A |
| | After reliability test | 50 cycles | A | A | A | A | A | A | A | A | A |
| | | 100 cycles | A | A | B | A | A | B | A | A | B |
| | | 300 cycles | A | B | B | A | B | B | A | B | B |
| | | 500 cycles | B | B | C | B | B | B | B | B | B |
| | | 1000 cycles | B | C | C | B | B | C | B | B | C |
| | Cracking in substrate | | Absence | Absence | Absence | Absence | Absence | Absence | Absence | Absence | Absence |

**[Table 11]**

| | | | Example 55 | Example 56 | Example 57 | Example 58 | Example 59 | Example 60 | Example 61 | Example 62 | Example 63 |
|---|---|---|---|---|---|---|---|---|---|---|---|
| Metal Paste | | | Preparation Example S | Preparation Example S | Preparation Example S | Preparation Example T | Preparation Example T | Preparation Example T | Preparation Example U | Preparation Example U | Preparation Example U |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 50 | 100 | 30 | 50 | 100 | 30 | 50 | 100 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ | 100% H₂ |
| Concentration of metal particles in metal paste part (% by mass) | | Before drying (step a) | 95.1 | 95.1 | 95.1 | 95.3 | 95.3 | 95.3 | 96.2 | 96.2 | 96.2 |
| | | After drying (step b) | 97.5 | 97.5 | 97.5 | 97.6 | 97.6 | 97.6 | 98.1 | 98.1 | 98.1 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 0.6 | 0.6 | 0.6 | 0.6 | 0.6 | 0.6 | 0.6 | 0.6 | 0.6 |
| | | Criteria | A | A | A | A | A | A | A | A | A |
| | Recess after resist peeling | (µm) | 0.8 | 0.8 | 0.8 | 0.8 | 0.8 | 0.8 | 0.8 | 0.8 | 0.8 |
| | | Criteria | A | A | A | A | A | A | A | A | A |
| | Porosity (%) | | 6 | 6 | 6 | 5 | 5 | 5 | 3 | 3 | 3 |
| Wiring board | Initial resistance value | | A | A | A | A | A | A | A | A | A |
| | After reliability test | 50 cycles | A | A | A | A | A | A | A | A | A |
| | | 100 cycles | A | B | B | A | A | B | A | A | B |
| | | 300 cycles | B | B | C | A | B | B | A | B | B |
| | | 500 cycles | B | C | C | A | B | C | A | B | B |
| | | 1000 cycles | B | C | C | A | C | C | A | B | C |
| | Cracking in substrate | | Absence | Absence | Absence | Absence | Absence | Absence | Absence | Absence | Absence |

**[Table 12]**

| | | | Example 64 | Example 65 | Example 66 | Example 67 | Example 68 | Example 69 | Example 70 | Example 71 | Example 72 |
|---|---|---|---|---|---|---|---|---|---|---|---|
| Metal Paste | | | Preparation Example V | Preparation Example V | Preparation Example V | Preparation Example W | Preparation Example W | Preparation Example W | Preparation Example W | Preparation Example W | Preparation Example W |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 50 | 100 | 30 | 50 | 100 | 100 | 100 | 100 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 350 | 350 | 350 |
| | | Atmosphere | 100% H₂ | 100% H₂ | 100% H₂ | 100% H₂ | 100% H₂ | 100% H₂ | Formic acid | Formic acid | Formic acid |
| Concentration of metal particles in metal paste part (% by mass) | | Before drying (step a) | 95.7 | 95.7 | 95.7 | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 1.5 | 1.5 | 1.5 | 1.7 | 1.7 | 1.7 | 1.7 | 1.7 | 1.7 |
| | | Criteria | B | B | B | B | B | B | B | B | B |
| | Recess after resist peeling | (µm) | 2.1 | 2.1 | 2.1 | 2.5 | 2.5 | 2.5 | 2.5 | 2.5 | 2.5 |
| | | Criteria | B | B | B | B | B | B | B | B | B |
| | Porosity (%) | | 4 | 4 | 4 | 4 | 4 | 4 | 4 | 4 | 4 |
| Wiring board | Initial resistance value | | A | A | A | A | A | A | A | A | A |
| | After reliability test | 50 cycles | A | A | A | A | A | A | A | A | A |
| | | 100 cycles | A | A | A | A | A | A | A | A | A |
| | | 300 cycles | A | A | B | A | A | A | A | A | A |
| | | 500 cycles | A | A | B | A | A | A | A | A | A |
| | | 1000 cycles | A | A | B | A | A | A | A | A | A |
| | Cracking in substrate | | Absence | Absence | Absence | Absence | Absence | Absence | Absence | Absence | Absence |

**[Table 13]**

| | | | Example 73 | Example 74 | Example 75 | Example 76 | Example 77 | Example 78 | Example 79 | Example 80 | Example 81 |
|---|---|---|---|---|---|---|---|---|---|---|---|
| Metal Paste | | | Preparation Example W | Preparation Example W | Preparation Example W | Preparation Example W | Preparation Example W | Preparation Example W | Preparation Example W | Preparation Example W | Preparation Example W |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 50 | 100 | 30 | 50 | 100 | 30 | 50 | 100 |
| | | Via depth (µm) | 300 | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee | Squeegee |
| Step d | | Temperature (°C) | 300 | 300 | 300 | 250 | 250 | 250 | 200 | 200 | 200 |
| | | Atmosphere | Formic acid | Formic acid | Formic acid | Formic acid | Formic acid | Formic acid | Formic acid | Formic acid | Formic acid |
| Concentration of metal particles in metal paste part (% by mass) | | Before drying (step a) | 95.7 | 95.7 | 95.7 | 95.7 | 95.7 | 95.7 | 95.7 | 95.7 | 95.7 |
| | | After drying (step b) | 97.8 | 97.8 | 97.8 | 97.8 | 97.8 | 97.8 | 97.8 | 97.8 | 97.8 |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 1.5 | 1.5 | 1.5 | 1.7 | 1.7 | 1.7 | 1.7 | 1.7 | 1.7 |
| | | Criteria | B | B | B | B | B | B | B | B | B |
| | Recess after resist peeling | (µm) | 2.5 | 2.5 | 2.5 | 2.5 | 2.5 | 2.5 | 2.5 | 2.5 | 2.5 |
| | | Criteria | B | B | B | B | B | B | B | B | B |
| | Porosity (%) | | 4 | 4 | 4 | 4 | 4 | 4 | 4 | 4 | 4 |
| Wiring board | Initial resistance value | | A | A | A | A | A | A | A | A | B |
| | After reliability test | 50 cycles | A | A | A | A | A | A | A | A | A |
| | | 100 cycles | A | A | A | A | A | A | A | A | A |
| | | 300 cycles | A | A | A | A | A | A | A | A | B |
| | | 500 cycles | A | A | A | A | A | A | A | A | B |
| | | 1000 cycles | A | A | A | A | A | A | A | A | B |
| | Cracking in substrate | | Absence | Absence | Absence | Absence | Absence | Absence | Absence | Absence | Absence |

**[Table 14]**

| | | | I Example 82 | Example 83 | I Example 84 | Example 85 | Example 86 | Example 87 |
|---|---|---|---|---|---|---|---|---|
| Metal Paste | | | Preparation Example W | Preparation Example W | Preparation Example W | Preparation Example W | Preparation Example W | Preparation Example W |
| Substrate | | Material | Silicon | Silicon | Silicon | Silicon | Silicon | Silicon |
| | | Hole type | Through-hole | Through-hole | Through-hole | Through-hole | Through-hole | Through-hole |
| | | Via diameter (µm) | 30 | 50 | 100 | 30 | 50 | 100 |
| | | Via depth (µm) | 300 | 300 | 300 | 300 | 300 | 300 |
| Step a | | Filling method | Vacuum press | Vacuum press | Vacuum press | Vacuum press | Vacuum press | Vacuum press |
| Step b | | Temperature (°C) | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee |
| Step d | | Temperature (°C) | 150 | 150 | 150 | 120 | 120 | 120 |
| | | Atmosphere | Formic acid | Formic acid | Formic acid | Formic acid | Formic acid | Formic acid |
| Concentration of metal particles in metal paste part (% by mass) | | Before drying (step a) | 95.7 | 95.7 | 95.7 | 95.7 | 95.7 | 95.7 |
| | | After drying (step b) | 97.8 | 97.8 | 97.8 | 97.8 | 97.8 | 97.8 |
| Conductive via | Crack | | Absence | Absence | Absence | Absence | Absence | Absence |
| | Void | | Absence | Absence | Absence | Absence | Absence | Absence |
| | Recess after sintering | (µm) | 1.7 | 1.7 | 1.7 | 1.7 | 1.7 | 1.7 |
| | | Criteria | B | B | B | B | B | B |
| | Recess after resist peeling | (µm) | 2.5 | 2.5 | 2.5 | 2.5 | 2.5 | 2.5 |
| | | Criteria | B | B | B | B | B | B |
| | Porosity (%) | | 4 | 4 | 4 | 5 | 5 | 5 |
| Wiring board | Initial resistance value | | B | B | B | B | B | B |
| | After reliability test | 50 cycles | A | A | A | A | A | A |
| | | 100 cycles | A | A | A | A | B | B |
| | | 300 cycles | A | A | B | B | B | B |
| | | 500 cycles | A | A | B | B | B | C |
| | | 1000 cycles | A | A | B | B | B | C |
| | Cracking in substrate | | Absence | Absence | Absence | Absence | Absence | Absence |

**[Table 15]**

| | | | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|
| Metal Paste | | | Comparative Preparation Example A | Comparative Preparation Example B | Comparative Preparation Example C | Comparative Preparation Example D | Comparative Preparation Example E | Comparative Preparation Example F | Comparative Preparation Example G | Comparative Preparation Example H |
| Substrate | | Material | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole |
| | | Via diameter (µm) | 30 | 30 | 30 | 30 | 30 | 30 | 30 | 30 |
| | | Via depth (µm) | 300 | 300 | 300 | 300 | 300 | 300 | 300 | 300 |
| Step a | | Filling method | Vacuum press | Vacuum press | Vacuum press | Vacuum press | Vacuum press | Vacuum press | Vacuum press | Vacuum press |
| Step b | | Temperature (°C) | 90 | 90 | 90 | 90 | 90 | 90 | 90 | 90 |
| | | Atmosphere | Ambient atmosphere | Ambient atmosphere | Ambient atmosphere | Ambient atmosphere | Ambient atmosphere | Ambient atmosphere | Ambient atmosphere | Ambient atmosphere |
| Step c | | Removing method | Squeegee | Squeegee | Squeegee | Squeegee | Squeegee | Squeegee | Squeegee | Squeegee |
| Step d | | Temperature (°C) | 300 | 300 | 300 | 300 | 300 | 300 | 300 | 300 |
| | | Atmosphere | 100% H₂ | 100% H₂ | 100% H₂ | 100% H₂ | 100% H₂ | 100% H₂ | 100% H₂ | 100% H₂ |
| Concentration of metal particles in metal paste part (% by mass) | | Before drying (step a) | 95 | 95.1 | 95.3 | 95.8 | 95.7 | 95.6 | 95.2 | 95.2 |
| | | After drying (step b) | 97.5 | 97.5 | 97.6 | 97.9 | 97.9 | 97.8 | 97.4 | 97.4 |
| Conductive via | Crack | | Absence | Absence | Absence | Absence | Absence | Absence | Presence | Presence |
| | Void | | Absence | Absence | Absence | Absence | Absence | Absence | Presence | Presence |
| | Recess after sintering | (µm) | 0.9 | 0.9 | 0.9 | 0.6 | 0.6 | 0.6 | 4.3 | 4,5 |
| | | Criteria | A | A | A | A | A | A | C | C |
| | Recess after resist peeling | (µm) | 1.4 | 1.4 | 1.4 | 1 | 1.1 | 1.2 | 6.7 | 7.3 |
| | | Criteria | B | B | B | B | B | B | D | D |
| | Porosity (%) | | 8 | 7 | 6 | 8 | 7 | 6 | 9 | 9 |
| Wiring board | Initial resistance value | | A | A | A | A | A | A | C | C |
| | After reliability test | 50 cycles | B | B | B | B | B | B | D | C |
| | | 100 cycles | C | C | C | C | C | C | E | D |
| | | 300 cycles | D | D | D | D | D | D | E | E |
| | | 500 cycles | E | E | E | E | E | E | E | E |
| | | 1000 cycles | E | E | E | E | E | E | E | E |
| | Cracking in substrate | | Absence | Absence | Absence | Absence | Absence | Absence | Absence | Absence |

**[Table 16]**

| | | | Comparative Example 9 | Comparative Example 10 | Comparative Example 11 |
|---|---|---|---|---|---|
| Metal Paste | | | Comparative Preparation Example I | Comparative Preparation Example I | Comparative Preparation Example I |
| Substrate | | Material | Silicon | Silicon | Silicon |
| | | Hole type | Through-hole | Through-hole | Through-hole |
| | | Via diameter (µm) | 30 | 50 | 100 |
| | | Via depth (µm) | 300 | 300 | 300 |
| Step a | | Filling method | Vacuum press | Vacuum press | Vacuum press |
| Step b | | Temperature (°C) | 90 | 90 | 90 |
| | | Atmosphere | Ambient atmosphere | Ambient atmosphere | Ambient atmosphere |
| Step c | | Removing method | Squeegee | Squeegee | Squeegee |
| Step d | | Temperature (°C) | 300 | 300 | 300 |
| | | Atmosphere | 100% H₂ | 100% H₂ | 100% H₂ |
| Concentration of metal particles in metal paste part (% by mass) | | Before drying (step a) | 94.7 | 94.7 | 94.7 |
| | | After drying (step b) | 97.3 | 97.3 | 97.3 |
| Conductive via | Crack | | Presence | Presence | Presence |
| | Void | | Presence | Presence | Presence |
| | Recess after sintering | (µm) | 1.2 | 1.2 | 1.2 |
| | | Criteria | B | B | B |
| | Recess after resist peeling | (µm) | 2.1 | 2.1 | 2.1 |
| | | Criteria | B | B | B |
| | Porosity (%) | | 8 | 8 | 8 |
| Wiring board | Initial resistance value | | B | B | B |
| | After reliability test | 50 cycles | B | B | D |
| | | 100 cycles | C | C | E |
| | | 300 cycles | C | D | E |
| | | 500 cycles | C | E | E |
| | | 1000 cycles | D | E | E |
| | Cracking in substrate | | Absence | Absence | Absence |

### [Production of Silicon Substrates with Conductive Vias - 2]

### (Examples 88 to 91)

Silicon substrates with conductive vias were produced by the following procedure.

### [Preparation of Metal Paste]

### (Preparation Example a)

The raw materials shown above were mixed at the ratios shown in Table 17 using a three-roll mill to prepare a metal paste, and the properties were confirmed in the same manner as described above.

**[Table 17]**

| | | | | | Preparation Example a |
|---|---|---|---|---|---|
| Composition | Copper particles | First copper particles | Wet copper powder | Spherical copper particles W4 | 20 |
| | | | | Flat copper particles W2 | 20 |
| | | | Atomized copper powder | Spherical copper particles A2 | 20 |
| | | Second copper particles | Wet copper powder | Spherical copper particles W5 | 30 |
| | Volatile solvent | High vapor pressure solvent | α-Terpineol (6.5Pa) | | 2 |
| | | Low vapor pressure solvent | Diethylene glycol mono-n-butyl ether | | 2 |
| Content of metal particles in metal paste (% by mass) | | | | | 95.7 |
| Properties | Viscosity (Pa·s@25°C) | | | | 230 |
| | Printability | Criteria | | | A |
| | | Coating amount (g) | | | 5.5 |
| | Bondability | Bonding strength with Cu (N) | | | 70 |
| | | Criteria | | | A |
| | Volume resistivity (µΩ·cm) | | | | 3.8 |

### <Preparation of Silicon Substrate>

A silicon substrate having through-holes and including a titanium layer, a nickel layer, and a copper layer layered in this order on both main surfaces and on wall surfaces of the through-holes was prepared. The silicon substrate had a diameter of 6 inches and a thickness of 300 µm, and the titanium layer, the nickel layer, and the copper layer were sequentially formed by sputtering. Substrates having through-holes with diameters (via diameters) of 50, 90, 150, and 200 µm were prepared, respectively.

### <Production of Metal Particle Film>

The metal paste of Preparation Example a prepared as described above was printed on a PET film having a thickness of 100 µm with a screen printer in a size of 8-inch ⌀ (circular shape with a diameter of 20 cm) using a screen printing plate (wire diameter: 23 µm, the number of meshes: 400, mesh size: 41 µm, and space ratio: 41 µm) to obtain a metal particle film provided with a metal particle-containing layer.

### <Formation of Conductive Via>

The metal particle film was bonded to the silicon substrate from the metal particle-containing layer side with a bonding device VJ-35 (manufactured by Ayumi Industry Co., Ltd.), and the resulting laminate was further vacuum-pressed at room temperature at a pressure of 3 MPa to fill the through-holes with the metal paste. At this time, the metal paste was protruded from the side of the silicon substrate opposite to the side on which the metal particle film was bonded.

Subsequently, the laminate from which the PET film was peeled off was dried in the ambient atmosphere at 90°C for 10 minutes. The concentrations (% by mass) of the metal particles in the metal paste part before and after drying were 95.7% by mass and 97.8% by mass, respectively.

For the dried laminate, as illustrated in FIGS. 3(a) to 3(d), the metal paste on the main surface of the silicon substrate on the side on which the metal particle film was bonded was removed using a rubber squeegee, and subsequently, the metal paste protruding from the side of the silicon substrate opposite to the side on which the metal particle film was bonded was removed using the rubber squeegee.

Subsequently, the silicon substrate having conductive via precursors formed in the through-holes by the above-described steps was placed in a tube furnace (manufactured by AVC Co., LTD.), and argon gas flowed at a flow rate of 1 L/min to replace air in the tube furnace with argon gas. Thereafter, the temperature was increased to 300°C over 10 minutes while hydrogen gas flowed at 300 mL/min, and a sintering treatment was carried out at 300°C for 60 minutes to sinter the conductive via precursors. Thereafter, the resulting substrate was cooled while argon gas flowed at a flow rate of 0.3 L/min and taken out into air at 50°C or lower to obtain a silicon substrate with conductive vias.

For the substrate with conductive vias obtained as described above, the presence or absence of cracks and voids in the conductive vias, the porosity of the conductive vias, and the recess(es) after sintering were evaluated in accordance with the above-described methods.

### [Production of Wiring Board]

### (Examples 88 to 91)

For the silicon substrate with conductive vias obtained as described above (via diameters: 50, 90, 150, and 200 µm), conductive vias having a resin-containing part containing a photosensitive resin composition were formed by the following procedure, and a wiring was further formed to obtain a wiring board, and the evaluation thereof was performed.

A dry film "RD-1619" (manufactured by Resonac Corporation, trade name) for an ultraviolet curable etching resist (photosensitive resin composition F1) was laminated on the surface of the glass substrate with metal sintered body obtained as described above by atmospheric pressure lamination under the conditions of a roll pressure of 3 MPa, a processing temperature of 120°C, and a conveyance speed of 1.0 m/s to form a dry film resist layer. Next, the dry film resist layer was exposed in a predetermined pattern using a direct imaging exposure machine "DE-1UH" (manufactured by Via Mechanics, Ltd., product number) under the condition of 55 mJ/cm². One minute later, a PEB (Post Exposure Bake) treatment was performed at 70°C for 1 minute, and subsequently, a treatment was performed using a developer of sodium carbonate at a concentration of 1% at a spray pressure of 0.17 MPa at 30°C for 70 seconds, and residues were further removed by oxygen plasma treatment to form a resist pattern. After performing an etching treatment (ammonium persulfate: 100 g/L, R.T., 30 seconds) and a surface treatment with a sulfuric acid aqueous solution (100 g/L, R.T., 30 seconds), electrolytic plating was performed on the openings of the resist. Thereafter, peeling of the resist and etching of the seed layer were carried out to form a wiring having a wiring pattern of 300 µm × 600 µm, thereby obtaining a test piece 55 (wiring board) as illustrated in FIG. 5. The wiring pattern was finished to have a thickness of about 10 µm after etching of the seed layer. In the test piece 55, the conductive vias formed in the through-holes are electrically connected by the wiring provided on the substrate surface.

### [Impregnation Depth of Photosensitive Resin Composition into Porous Part of Conductive Via]

The cross-section of the conductive via of the glass substrate with conductive vias was exposed by cross-section polishing, the surface was cleaned by ion milling, and the cross-section was observed. Using a scanning electron microscope S-3700N (manufactured by Hitachi High-Tech Corporation), the impregnation depth of the photosensitive resin composition (or a cured product thereof) into the porous part was measured. The distance from the via surface to the porous (void) part was measured at 10 points, and the mean value thereof was taken as the impregnation depth.

### [Evaluation of Wiring Board]

For the test piece obtained as described above, the initial resistance value, the connection reliability, and the recess on the surface of the wiring pattern formed on the conductive via were evaluated in accordance with the following methods.

### <Initial Resistance Value>

As the initial resistance value of the test piece 55 (wiring board), a resistance value of 1,000 interconnected vias was measured. The initial resistance value was evaluated based on this connection resistance value according to the following criteria.

### (Number of Vias)

1,000

### (Criteria)

A: The resistance value is less than 6 Ω.
B: The resistance value is 6 Ω or more and less than 10 Ω.
C: The resistance value is 10 Ω or more and less than 20 Ω.
D: The resistance value is 20 Ω or more and less than 50 Ω.
E: The resistance value is 50 Ω or more.

### <Connection Reliability - Temperature Cycle Test>

The test piece 55 (wiring board) was set in a temperature cycle tester (TSA-72SE-W, manufactured by ESPEC CORP.), and a temperature cycle connection reliability test was carried out under the conditions of low temperature side: -55°C, 15 minutes, room temperature: 2 minutes, high temperature side: 125°C, 15 minutes, defrosting cycle: automatic, and the number of cycles: 50, 100, 300, 500, and 1,000 cycles. For the test piece after undergoing each of the number of cycles, a resistance value of the above-described number of interconnected vias was measured. The connection reliability was evaluated based on this connection resistance value according to the following criteria.

### (Criteria)

A: The resistance change rate is less than 1% with respect to initial resistance value.
B: The resistance change rate is 1% or more and less than 3% with respect to the initial resistance value.
C: The resistance change rate is 3% or more and less than 5% with respect to the initial resistance value.
D: The resistance change rate is 5% or more and less than 10% with respect to the initial resistance value.
E: The resistance change rate is 10% or more and less than 20% with respect to the initial resistance value.
F: The resistance change rate is 20% or more with respect to the initial resistance value.
G: Conduction failure occurred.

### <Connection Reliability - 150°C>

The test piece 55 was set in a high-temperature chamber (precision constant temperature chamber DH612, manufactured by Yamato Scientific Co., Ltd.) and left at 150°C for 50, 100, 300, and 500 hours to carry out a high-temperature storage test. For the test piece after undergoing each of the time periods, a resistance value of the above-described number of interconnected vias was measured. The connection reliability was evaluated based on this connection resistance value according to the following criteria.

### (Criteria)

A: The resistance change rate is less than 1% with respect to the initial resistance value.
B: The resistance change rate is 1% or more and less than 3% with respect to the initial resistance value.
C: The resistance change rate is 3% or more and less than 5% with respect to the initial resistance value.
D: The resistance change rate is 5% or more and less than 10% with respect to the initial resistance value.
E: The resistance change rate is 10% or more and less than 20% with respect to the initial resistance value.
F: The resistance change rate is 20% or more with respect to the initial resistance value.
G: Conduction failure occurred.

### <Connection Reliability - 200°C>

The test piece 55 was set in a high-temperature chamber (precision constant temperature chamber DH612, manufactured by Yamato Scientific Co., Ltd.) and left at 200°C for 50, 100, 300, and 500 hours to carry out a high-temperature storage test. For the test piece after undergoing each of the time periods, a resistance value of the above-described number of interconnected vias was measured. The connection reliability was evaluated based on this connection resistance value according to the following criteria.

### (Criteria)

A: The resistance change rate is less than 1% with respect to the initial resistance value.
B: The resistance change rate is 1% or more and less than 3% with respect to initial resistance value.
C: The resistance change rate is 3% or more and less than 5% with respect to initial resistance value.
D: The resistance change rate is 5% or more and less than 10% with respect to the initial resistance value.
E: The resistance change rate is 10% or more and less than 20% with respect to the initial resistance value.
F: The resistance change rate is 20% or more with respect to the initial resistance value.
G: Conduction failure occurred.

### <Recess on Surface of Wiring Pattern Formed on Conductive Via>

The surface of the wiring pattern formed on the conductive via of the test piece 55 (wiring board) was observed for 30 conductive vias using a digital microscope (VHX-6000, manufactured by KEYENCE CORPORATION), the deepest point was measured, and the mean value thereof was taken as the recess on the surface of the wiring pattern.

### (Criteria)

A: The mean value of average step heights is less than 2 µm.
B: The mean value of average step heights is 2 µm or more and less than 4 µm.
C: The mean value of average step heights is 4 µm or more and less than 6 µm.
D: The mean value of average step heights is 6 µm or more and less than 8 µm.
E: The mean value of average step heights is 8 µm or more.

**[Table 18]**

| | | | Example 88 | Example 89 | Example 90 | Example 91 |
|---|---|---|---|---|---|---|
| Metal Paste | | | Preparation Example a | Preparation Example a | Preparation Example a | Preparation Example a |
| Substrate | | Material | Silicon | Silicon | Silicon | Silicon |
| | | Hole type | Through-hole | Through-hole | Through-hole | Through-hole |
| | | Via diameter (µm) | 50 | 90 | 150 | 200 |
| | | Via depth (µm) | 300 | 300 | 300 | 300 |
| Conductive via | Crack | | Absence | Absence | Absence | Absence |
| | Void | | Absence | Absence | Absence | Absence |
| | Recess after sintering | (µm) | 1.8 | 2.5 | 4.2 | 4.6 |
| | | Criteria | B | B | C | C |
| | Recess after resist peeling | (µm) | 2.5 | 3.2 | 4.7 | 5.6 |
| | | Criteria | B | C | C | D |
| | Porosity of conductive via (%) | | 4 | 4 | 4 | 4 |
| Photosensitive resin composition | | | F1 | F1 | F1 | F1 |
| Impregnation depth of photosensitive resin composition into metal sintered body (µm) | | | 7 | 7 | 7 | 7 |
| Wiring board | Recess on surface of wiring pattern formed on conductive via (µm) | | A | A | A | A |
| | Initial resistance value | | A | A | A | A |
| | After reliability test (temperature cycle) | 50 cycles | A | A | A | A |
| | | 100 cycles | A | A | A | A |
| | | 300 cycles | A | A | A | A |
| | | 500 cycles | A | A | A | A |
| | | 1000 cycles | A | A | A | A |
| | After reliability test (150°C) | 50 hours | A | A | A | A |
| | | 100 hours | A | A | A | A |
| | | 300 hours | A | A | A | A |
| | | 500 hours | B | B | B | B |
| | After reliability test (200°C) | 50 hours | A | A | A | A |
| | | 100 hours | A | A | A | A |
| | | 300 hours | A | A | A | A |
| | | 500 hours | B | B | B | B |

### [Production of Organic Substrate with Conductive Vias]

### (Examples 92 to 95)

Organic substrates with conductive vias were produced by the following procedure.

### <Preparation of Organic Substrate>

A high-Tg glass epoxy multilayer material MCL-E-679F(J) (manufactured by Resonac Corporation) having a board thickness of 300 µm with 1 µm copper foil bonded on both sides was prepared, and through-holes having hole diameters (via diameters) of 90, 150, and 200 µm were provided. A copper plating film having a thickness of 0.5 µm was formed inside the vias by electroless copper plating.

Using the above-described organic substrate, an organic substrate with conductive vias and a wiring board were obtained and evaluated in the same manner as in Examples 89 to 91, except that the temperature was increased to 225°C over 10 minutes and a sintering treatment was carried out at 225°C for 60 minutes. The concentrations (% by mass) of the metal particles in the metal paste part before and after drying were 95.7% by mass and 97.8% by mass, respectively.

**[Table 19]**

| | | | Example 92 | Example 93 | Example 94 |
|---|---|---|---|---|---|
| Metal Paste | | | Preparation Example a | Preparation Example a | Preparation Example a |
| Substrate | | Material | Organic substrate | Organic substrate | Organic substrate |
| | | Hole type | Through-hole | Through-hole | Through-hole |
| | | Via diameter (µm) | 90 | 150 | 200 |
| | | Via depth (µm) | 300 | 300 | 300 |
| Conductive via | Crack | | Absence | Absence | Absence |
| | Void | | Absence | Absence | Absence |
| | Recess after sintering | (µm) | 2.2 | 4.3 | 4.8 |
| | | Criteria | B | C | C |
| | Recess after resist peeling | (µm) | 2.5 | 4.6 | 6.2 |
| | | Criteria | B | B | D |
| | Porosity of conductive via (%) | | 4 | 4 | 4 |
| Photosensitive resin composition | | | F1 | F1 | F1 |
| Impregnation depth of photosensitive resin composition into metal sintered body (µm) | | | 7 | 7 | 7 |
| Wiring board | Recess on surface of wiring pattern formed on conductive via (µm) | | A | A | A |
| | Initial resistance value | | B | B | B |
| | After reliability test (temperature cycle) | 50 cycles | A | A | A |
| | | 100 cycles | A | A | A |
| | | 300 cycles | A | A | A |
| | | 500 cycles | A | A | A |
| | | 1000 cycles | A | A | A |
| | After reliability test (150°C) | 50 hours | A | A | A |
| | | 100 hours | A | A | A |
| | | 300 hours | A | A | A |
| | | 500 hours | B | B | B |
| | After reliability test (200°C) | 50 hours | A | A | A |
| | | 100 hours | A | A | A |
| | | 300 hours | A | A | A |
| | | 500 hours | B | B | B |

### Reference Signs List

- 1: Silicon wafer
- 2: Metal coating
- 3: Metal paste part
- 3b: Conductive via precursor
- 3c: Conductive via
- 3p: Metal particle-containing layer
- 7: Support film
- 8a: Etching resist
- 9: Wiring
- 30: Through-hole
- 31: Blind-hole
- 40, 41: Silicon substrate
- 42: Rubber squeegee
- 50: Substrate with conductive vias
- 52: Wiring board with conductive vias
- 55: Test piece
- A: Pressure jig

## Claims

1. A method for manufacturing a substrate with conductive vias, the method comprising:
step a of preparing a substrate provided with a hole and providing a metal paste part containing metal particles and a volatile solvent to cover at least a surface of the substrate surrounding the hole while filling an inside of the hole;
step b of heating the metal paste part to remove a part of the volatile solvent;
step c of removing a part of the metal paste part after heating to expose the surface, thereby forming a conductive via precursor in the inside of the hole, the conductive via precursor comprising the metal particles and a remainder of the volatile solvent and having a planarized exposed surface; and
step d of firing the conductive via precursor, wherein
the metal particles comprise first metal particles having a volume average particle diameter of 0.8 µm or more and second metal particles having a volume average particle diameter of 0.5 µm or less,
the metal paste part provided in step a has a metal particle concentration of 95.0% by mass or more, and
a content of the second metal particles in the metal paste part provided in step a is 50% by mass or less based on a total amount of the metal particles.

2. The method for manufacturing a substrate with conductive vias according to claim 1, wherein
the first metal particles and the second metal particles are copper particles.

3. The method for manufacturing a substrate with conductive vias according to claim 1 or 2, wherein
the first metal particles comprise flake-shaped copper particles.

4. A metal paste comprising metal particles and a volatile solvent, wherein
a content of the metal particles is 95.0% by mass or more based on the total amount of the metal paste,
the metal particles comprise first metal particles having a volume average particle diameter of 0.8 µm or more and second metal particles having a volume average particle diameter of 0.5 µm or less, and
a content of the second metal particles is 50% by mass or less based on a total amount of the metal particles.

5. The metal paste according to claim 4, wherein
the first metal particles and the second metal particles are copper particles.

6. The metal paste according to claim 4 or 5, wherein
the first metal particles comprise flake-shaped copper particles.

7. A substrate with conductive vias, comprising:
a substrate having a through-hole; and
a conductive via provided in the through-hole, wherein
the conductive via comprises a sintered body of the metal paste according to claim 4 or 5.
